# EUROPEAN PATENT SPECIFICATION

(11) **EP 0 594 162 B1**
(45) Date of publication and mention of the grant of the patent: **01.07.1998**
(21) Application number: 93117029.4
(22) Date of filing: 21.10.1993
(51) Int. Cl.: G05F 1/46

(54) **Wide range power supply for integrated circuits**
Stromversorgung mit grossem Bereich für integrierte Schaltungen
Source d'alimentation à gamme étendue pour circuits integrés

(30) Priority: 22.10.1992 US 964912; 14.12.1992 US 991533; 11.01.1993 US 3028; 12.01.1993 US 3450
(43) Date of publication of application: 27.04.1994
(73) Proprietor: UNITED MEMORIES, INC., Colorado Springs, CO 80919 (US); Nippon Steel Semiconductor Corporation, Tateyama-shi, Chiba 294 (JP)
(72) Inventor: Hardee, Kim C., Colorado Springs, CO 80920 (US); Cordoba, Michael V., Colorado Springs, CO 80906 (US)
(74) Representative: Bosotti, Luciano

(56) References cited:
- DE-A- 3 923 632
- DE-A- 4 115 082
- GB-A- 2 248 357
- US-A- 4 994 688

## Description

This invention relates to a power supply for an integrated circuit and more particularly to a power supply circuit for receiving a voltage within a wide range of external voltages and generating or providing plural (non-zero) internal voltages over a wide range.

Integrated circuits include a number of input pins. One pin is for a power supply voltage, often called VCC, and another is for ground, also called VSS, which is generally 0 volts. There is very strong resistance against adding any additional voltage supply pin. However, some integrated circuits call for different internal voltages, and these voltages must be generated internally.

Previously, integrated circuits generating such different internal voltages would operate within a very narrow input power supply range. For example, a 3.3 volt device may operate on an input power supply range of 3.0 volts to 3.6 volts, and a 5 volt device may operate in the range of 4.5 to 5.5 volts. Generally, these integrated circuits are designed for either a 3.3 volt input or a 5 volt input. If a device designed to receive a 3.3 volt input were operated at 5 volts, it would consume too much power and would not be reliable. Conversely, if a device designed to receive a 5 volt input were supplied with only 3.3 volts, it would either be very slow or not work at all.

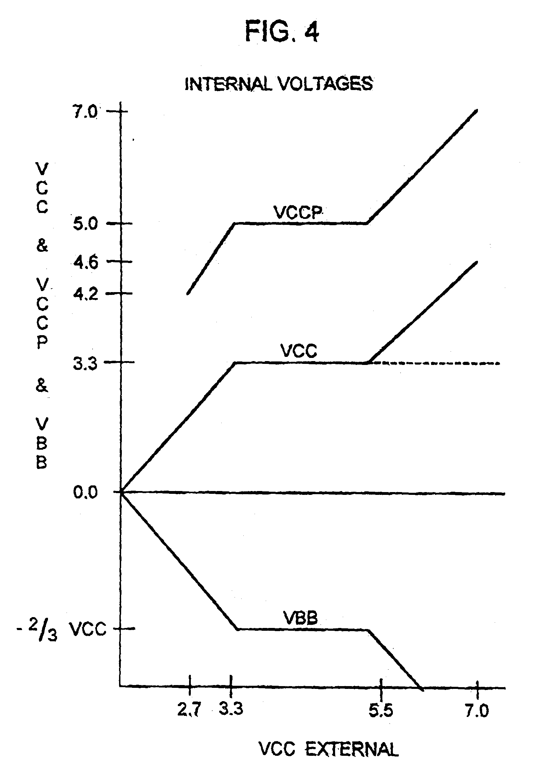

K. Noda et al., "A Boosted Dual Word-Line Decoding Scheme for 256 Mb DRAMs" 1992 Symposium on VLSI Circuits, Digest of Technical Papers (IEEE 1992) discloses a power supply scheme for DRAMs having three voltage levels, an external VCC, an internal limited voltage V_{LIM} and a boosted voltage V_{BOOT}. In particular, as shown in Fig. 4 thereof, a voltage limiter circuit receives a reference voltage V_{REF} and the external VCC to generate V_{LIM}. The booster circuit receives V_{LIM} to generate V_{BOOT}.

More specifically, the present invention relates to a power supply circuit having the features set forth in the pre-characterising portion of Claim 1, which is known, e.g. from US-A-4 994 688.

An object of a present invention is to provide a power supply for use within integrated circuits which is able to operate within such a wide range of input voltages, to generate separate voltages to drive low voltage circuits and high voltage circuits, and to maintain the potential at the substrate of an integrated circuit.

Another object of the present invention is to provide a power supply for integrated circuits which operates on a low input voltage which is coupled to low voltage circuits and which generates a voltage to drive high voltage circuits and a voltage to maintain the potential at the substrate of an integrated circuit.

Another object of the present invention is to provide a power supply for integrated circuits which operates on a high input voltage which is coupled to high voltage circuits and which generates a voltage to drive low voltage circuits and a voltage to maintain the potential at the substrate of an integrated circuit.

The wide range power supply for integrated circuits of the present invention having the further features set forth in Claim 1, can operate within a wide range of input supply voltages to provide: (a) a low voltage internal supply signal, (b) a high voltage internal supply signal, and (c) a substrate bias signal. In its preferred form, the present invention includes a voltage-down converter ("VDC") to receive the input supply voltage and generate a controlled low voltage signal. Because the low voltage signal is controlled, this signal can be used within the circuit to drive circuits or generate other signals which are independent of variations in the input supply voltage.

The circuit also includes a voltage-up converter ("VUC") which receives the controlled low voltage signal to generate a high voltage signal for high voltage circuits. Finally, the circuit includes a substrate bias generator which generates a substrate voltage signal to maintain the potential at the substrate of the semiconductor device. Because the low voltage signal is controlled, the high voltage and the substrate voltage signals are independent of variations in the input supply voltage. Although the circuit of the present invention could be used with any integrated circuit, the circuit is particularly useful for DRAMs and other memory devices.

In an alternate embodiment, the input supply voltage is generally low (for example, 3.3 volts) and is controlled. Therefore. the input supply voltage is used to drive low voltage circuits, and no voltage-down converter is required. The alternate embodiment, however, includes a voltage-up converter to generate a high voltage and a substrate bias generator for maintaining the substrate voltage.

Finally, another alternate embodiment for receiving a high voltage input supply is disclosed. This embodiment is employed when the input supply voltage is high (for example, 5 volts) and is controlled. Therefore, the input supply voltage is used to power the high voltage circuits, eliminating the need for a voltage-up converter. This embodiment, however, includes a voltage-down converter for generating a low voltage and a substrate bias generator for maintaining the substrate voltage.

In describing the present invention, reference is made to the accompanying drawings, wherein:
Figure 1 is a block diagram of the first embodiment of the wide range power supply for integrated circuits where the power supply can operate within a wide range of input supply voltages to provide a low voltage internal supply signal and a high voltage internal supply signal;
Figure 2 is a block diagram of a circuit of a wide range power supply for integrated circuits preferably used with a low voltage input supply;
Figure 3 is a block diagram of a circuit of a wide range power supply for integrated circuits preferably used with a high voltage input supply; and
Figure 4 is a plot of the VCC, VCCP and VBB voltages as a function of the input supply voltage.
Fig. 5 is a block diagram of the preferred VDC generator 24.
Fig. 6 is a detailed block diagram of a first embodiment of the Fig. 5 embodiment.
Fig. 7 is a schematic diagram of the switching circuit and the fuse circuit of Fig. 6.
Fig. 8 is a schematic diagram of the predecoder circuit of Fig. 6.
Fig. 9 is a schematic diagram of the reference voltage generator circuit of Fig. 6.
Fig. 10 is a schematic diagram of the second voltage comparator of Fig. 6.
Fig. 11 is a schematic diagram of the first voltage comparator of Fig. 6.
Fig. 12 is a schematic diagram of the internal voltage generator of Fig. 6.
Fig. 13 is a schematic diagram of the VDIVIDE circuit of the Fig. 6 embodiment.
Fig. 14 is a flow chart diagram of the use of the Fig. 5 embodiment.
Fig. 15 is a graph of the internal voltage generated by the Fig. 5 embodiment.
Fig. 16 is a detailed block diagram of a second embodiment of the VDC generator 24.
Fig. 17 is a schematic diagram of the voltage divider controller of Fig. 16.
Fig. 18 is a schematic diagram of the voltage divider of Fig. 16.
Fig. 19A is a schematic diagram of the reference voltage generator of Fig. 16.
Figure 19B is a block diagram of the substrate bias generator circuit according to a preferred embodiment of the present invention;
Figure 20 is a block diagram of the substrate voltage regulator circuit of Figure 19B;
Figure 21 is a timing diagram showing input and output signals to the substrate voltage regulator circuit of Figure 20;
Figure 22 is a detailed schematic of the substrate voltage regulator circuit of Fig. 20;
Figure 23 is a block diagram of the clock circuit of Figure 19B;
Figure 24 is a detailed schematic of a first stage of the clock circuit of Figure 23;
Figure 25 is a detailed schematic of a second stage of the clock circuit of Figure 23;
Figure 26 is a schematic diagram of a charge pump circuit for receiving the signals generated by the clock circuit to pump the voltage at the substrate to a desired value; and
Figure 27 is a timing diagram of (i) clock signals generated in the first and second stages of the clock circuit of Figure 23 to drive the charge pump and (ii) voltages at nodes of the charge pump circuit of Figure 26 during the pumping and precharge cycles.
Figure 28 is a block diagram of an embodiment of the voltage generator according to the present invention.
Figure 29 is a block diagram of the voltage regulator circuit 1100 including standby regulator circuit 1110 and active regulator circuit 1200 shown in Figure 28.
Figure 30 is a detailed schematic of standby regulator circuit 1110 (shown in Figure 29) for the standby circuit.
Figure 31 is a detailed schematic of the standby master clock circuit of the standby clock circuit for generating a standby master clock signal.
Figure 32 is a block diagram of the clock circuit for both the standby clock and the active clock for generating clock signals for the standby pump and the active pump, respectively.
Figure 33 is a schematic diagram of the pump circuit used for the standby pump and the active pump.
Figure 34 is a timing diagram for the input and output signals and voltages at various nodes of the standby pump circuit.
Figure 35 is a detailed schematic of the active regulator circuit 1200 shown in Figure 29 for the active circuit.
Figure 36 is a detailed schematic of the active master clock circuit of the active clock circuit for generating a master clock signal.
Figure 37 is a timing diagram for the input and output signals and voltages at various nodes of the active pump circuit.
Figure 38 is a block diagram of a second embodiment of the voltage regulator circuit having no active regulator.
Figure 39 is a detailed schematic of the master clock circuit for the active pump for the second embodiment.

### System Block Diagrams

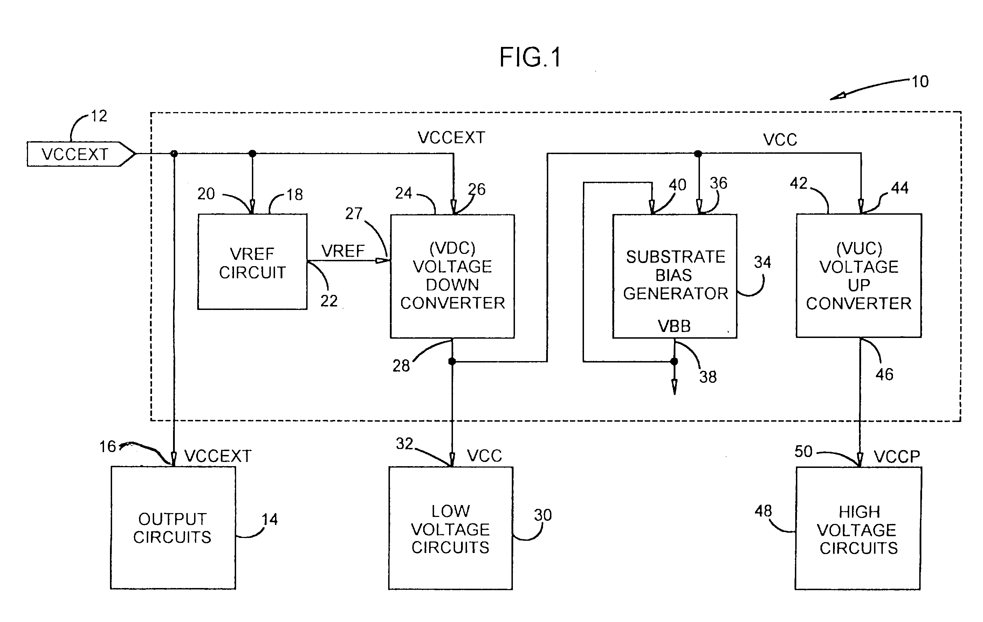

Turning first to Figure 1, a first embodiment of the wide range power supply for integrated circuits 10 is disclosed in the block diagram of Figure 1. Circuit 10 receives an input supply voltage called VCCEXT, which may be the voltage from the power supply pin. Circuit 10 generates therefrom a low voltage signal and a high voltage signal to drive separate low voltage and high voltage circuits, respectively. Specifically, the input supply voltage VCCEXT is coupled to the power supply circuit 10 at an input 12 and may be coupled also to various output circuits 14 at an input 16, if required to drive such output circuits. The input voltage VCCEXT is coupled also to a reference voltage circuit 18 at an input 20. Reference voltage circuit 18 generates an output VREF at an output 22. Reference voltage generator circuits are well known in the art, and any suitable reference voltage generator circuit could be used.

A voltage-down converter 24 receives VCCEXT at an input 26 and VREF at an input 27. Voltage-down converter 24 generates an output signal VCC at an output 28. Preferably, VCC is approximately 3.3 volts, although other values for VCC are possible.

The preferred voltage-down converter ("VDC") 24 is disclosed below, and constitutes a fuse-programmable, voltage-down converter that generates an internal voltage VCC (referred to as VCCINT). The voltage-down converter can be configured to maintain an optimal internal voltage.

Generally, the output VCC generated by the voltage-down converter is controlled and is constant despite variations in VCCEXT. While VCCEXT can vary from 3.0 volts to 5.5 volts, the preferred VDC circuit 24 will nevertheless generate a 3.3 volt VCC (or some other constant value). The controlled VCC signal is input to low voltage circuits 30 at an input 32, if required to drive such output circuits.

VCC is also input to a substrate bias generator 34 at an input 36. The substrate bias generator outputs a signal VBB at an output 38 to maintain the voltage at the substrate. The signal VBB is also fed back to an input 40 of the substrate bias generator to maintain VBB. Preferably VBB is maintained at approximately - (²/₃)VCC. A preferred example of a substrate bias generator for use in this invention is disclosed below. The oscillatorless substrate bias generator thereof maintains the voltage level on the substrate of an integrated circuit.

A voltage-up converter ("VUC") 42 also receives the controlled VCC signal at an input 44. The voltage-up converter generates at an output 46 an output signal VCCP the absolute value of which is generally greater than that of VCC. Because VCC is controlled, it is possible to generate a controlled VCCP output signal. The VCCP signal can be used to power high voltage circuits 48 (i.e. circuits requiring a voltage of 5 volts or more) at an input 50. The preferred voltage-up converter 42 is discussed below. However, other voltage-up converters which generate a voltage VCCP which is greater than VCC could be used within the scope of the present invention.

Thus, in broad terms, the circuitry of Figure 1 receives a voltage VCCEXT and from it generates a reference voltage VREF. Thus, VCCEXT and VREF are combined to produce a "low" supply voltage VCC (VCCINT), which is an output signal. Additionally, the generated VCC is used to generate a high supply voltage VCCP, which is a second output signal.

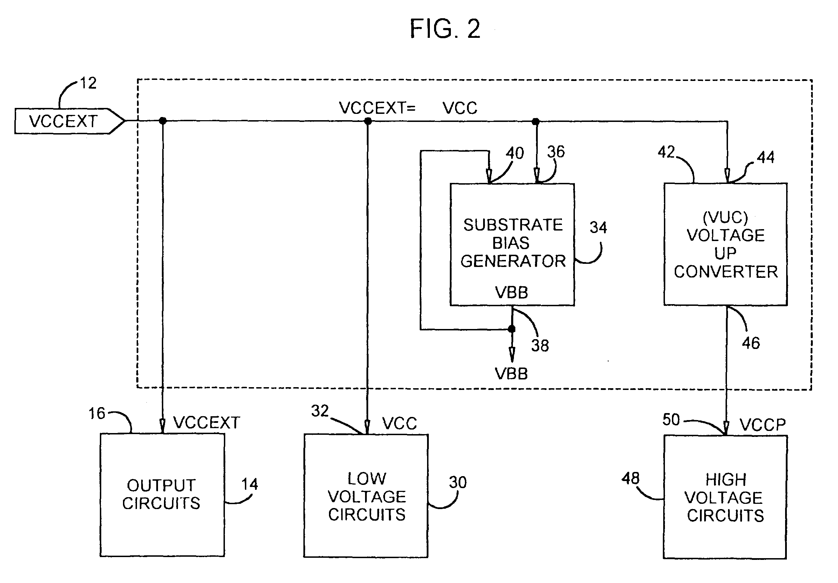

Figure 2 shows a second embodiment of a wide range power supply for integrated circuits. The second embodiment is preferably used with an input supply voltage which is generally low, approximately 3.0 to 3.6 volts. Accordingly, a reference voltage circuit 18 and a voltage-down converter 24 (shown in Figure 1) are not required. VCCEXT is used to drive output circuits 14 requiring a low voltage supply. Also, VCCEXT is used as the VCC signal which is input to low voltage circuits 30 at an input 32.

As in the embodiment of Figure 1, a substrate bias generator 34 receives VCC and VBB signals at inputs 36 and 40 respectively to output a VBB voltage to maintain the voltage at the substrate. Also, a voltage-up converter 42 receives VCC at an input 44. Converter 42 generates a VCCP signal, preferably a 5.0 volt signal, at an output 46. The VCCP signal is used to drive the high voltage circuits 48 at input 50 or could be output to drive output circuits requiring a high voltage supply signal.

The circuit of Figure 2 is based upon the circuit of Figure 1. However, VCCREF and the voltage-down converter are disabled. It is possible to manufacture the circuit of Figure 2 by changing only a single metal mask used in the production of the circuit of Figure 1. For example, such disabling can occur by disconnecting input 20 of reference voltage circuit 18 from VCCEXT, disconnecting input 26 of voltage down converter 24 from VCCEXT and connecting VCCEXT to output 28 of voltage down converter 24. Accordingly, a simplified circuit which will draw less current than the circuit of Figure 1 can be employed when the VCCEXT is controlled and generally a low voltage, for example, between 3.0 and 3.6 volts.

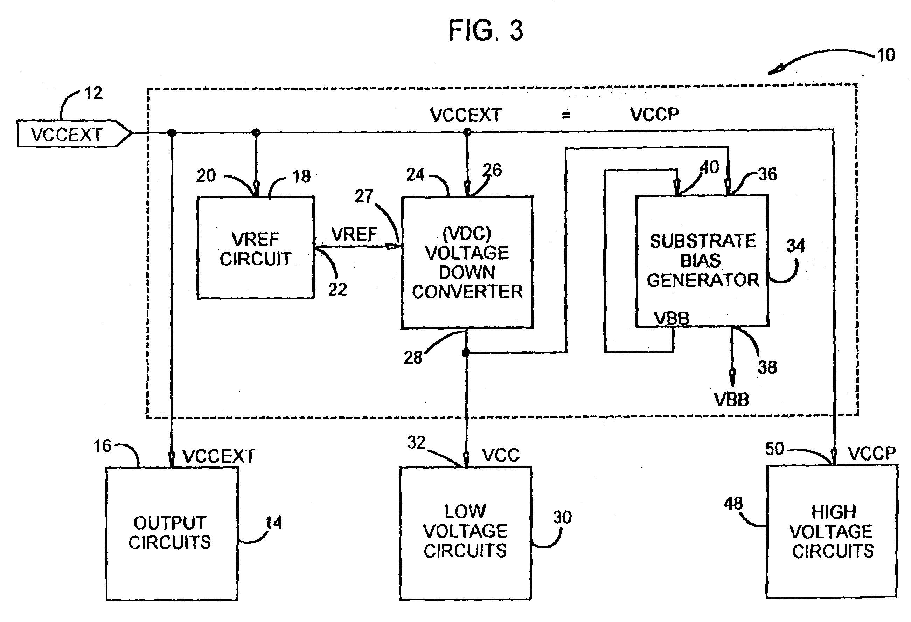

Figure 3 illustrates a circuit for receiving a high voltage input supply signal, for example between 4.5 and 5.5 volts. The wide range power supply for integrated circuits of Figure 3 receives VCCEXT at an input 12. VCCEXT is used to drive the output circuits 14 requiring a high voltage supply signal at input 16. Because VCCEXT is generally a controlled high voltage, it is used to drive the high voltage circuits 48 at input 50.

A VREF circuit 18 receives VCCEXT at an input 20 and generates from it a reference voltage VREF at an output 22. A voltage-down converter 24 receives the VCCEXT at an input 26 and reference voltage VREF at an input 27. The voltage-down converter generates a VCC of approximately 3.3 volts at an output 28. The VCC signal is used to drive the low voltage circuits 30 at an input 32. Also, VCC is input to the substrate bias generator 34 at an input 36 to maintain the voltage at the substrate.

The circuit of Figure 3 is similar to the circuit of Figure 1 except that the voltage-up converter 42 (shown in Figure 1) is disabled. The circuit of Figure 3 also may be manufactured based on the circuit of Figure 1 with the change in only one mask layer. Accordingly, if VCCEXT is known to be a high voltage, the circuit of Figure 3 can be easily manufactured by disabling the voltage-up converter. As a result, the circuit of Figure 3 will generally draw less current than the circuit of Figure 1.

Figure 4 graphically illustrates VCC, VCCP and VBB as a function of the voltage VCCEXT. For example, in the first embodiment, when VCCEXT varies between approximately 3.0 volts and 5.5 volts, it is possible to generate a VCC which is constant (approximately 3.3 volts) and a VCCP which is also constant (approximately 5.0 volts). If VCCEXT is controlled and low (approximately 3.3 volts), the voltage-down converter is not necessary and VCC equals VCCEXT (as disclosed in the embodiment of Figure 2). However, the circuit of Figure 2 includes a voltage-up converter to generate a VCCP of approximately 5 volts. Similarly, as disclosed in the circuit of Figure 3, if VCCEXT is high (approximately 5.0 volts), VCCP equals VCCEXT and is maintained at approximately 5.0 volts, while a voltage-down converter generates a VCC of approximately 3.3 volts.

To recapitulate, the circuit of the present invention is adaptable to receive a wide range of input supply voltages (for example between 3.0 and 5.5 volts) and to generate separate low voltage and high voltage signals to drive separate low voltage and high voltage circuits within an integrated circuit device. Preferably, the low voltage signal VCC is approximately 3.3 volts. Because the internal low voltage signal is controlled, it is independent of variations in the input supply voltage and can be used to generate other internal voltages, such as a high voltage VCCP. Preferably, the high voltage is approximately 5.0 volts. However, the circuits can be designed to generate other low and high voltage signals. Finally, a substrate bias generator may be included to maintain the voltage at the substrate of the semiconductor device.

### The Voltage-Down Converter

The preferred voltage converter 24 is a fuse-programmable voltage converter that generates an internal voltage VCCINT. This circuit permits full functional testing of a die over a range of voltages. Once the target internal voltage VCCINT is achieved for the circuit, the voltage converter can be configured to maintain the optimal internal voltage VCCINT.

A preferred embodiment of VDC 24 includes a counter used to enable a range of voltages for trimming the internal voltage to be used for full functional testing of the circuit. A fuse circuit is provided to maintain an input to a voltage down converter once the target internal voltage VCCINT is determined. The voltage down converter is provided to output the target internal voltage VCCINT to the circuit.

A method of operating the converter described herein may comprise the steps of: (1) passing a counter output and blocking a fuse circuit output; (2) supplying a range of voltage levels corresponding to the counter output for full functional testing of a die to determine the target internal voltage; and (3) blocking the counter output and passing the fuse circuit output that is configured to maintain the target internal voltage in conjunction with voltage down converter.

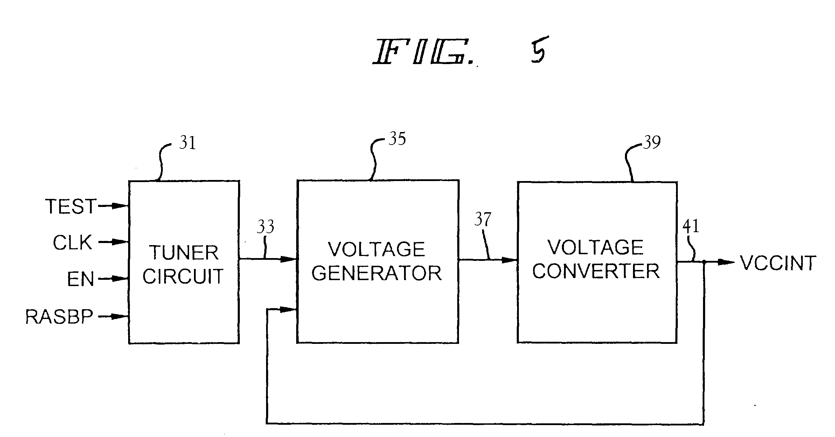

Fig. 5 is a block diagram of a voltage down converter circuit. It is coupled to receive signals TEST, EN, RASBP and CLK and apply them to a tuner circuit 31.

An output signal of tuner circuit 31 is supplied via a bus 33 to a voltage generator 35. An output signal of voltage generator 35 is supplied via a bus 37 to a voltage converter 39. Voltage converter 39 outputs an internal voltage VCCINT via a line 41. Line 41 is input to voltage generator 35.

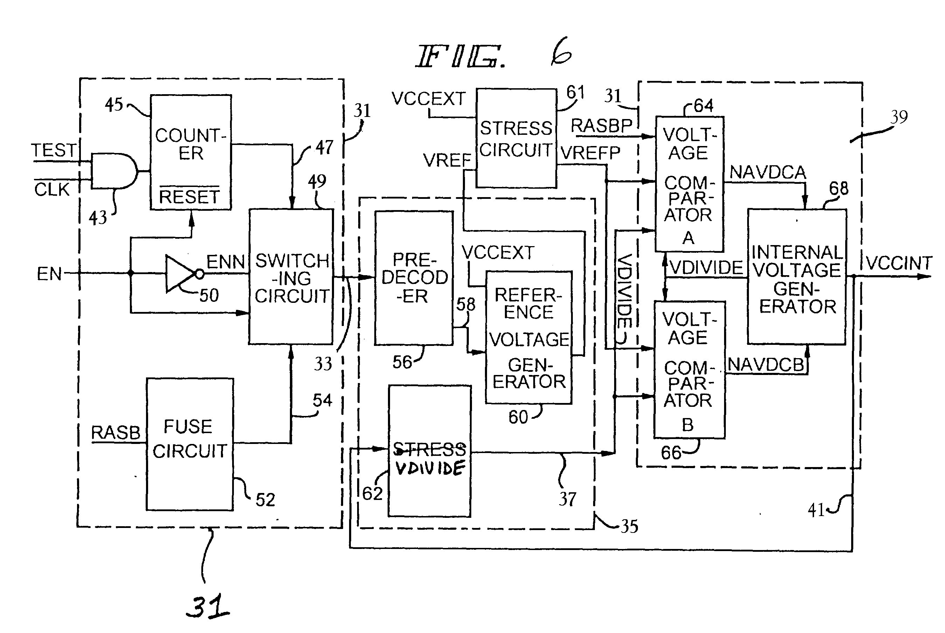

Fig. 6 is a more detailed block diagram of the Fig. 5 circuit. In Fig. 6, block 31 represents tuner circuit 31 of Fig. 5, block 35 represents voltage generator 35 of Fig. 2, and block 39 represents voltage generator 39 of Fig. 5.

Referring to block 31, signals TEST and CLK are input to a logic gate 43, preferably an AND gate. An output signal of logic gate 43 is supplied to a clock input of a counter 45. Signal EN is coupled to a reset input of counter 45. An output signal of counter 45 is coupled by a count bus 47 to a switching circuit 49. Preferably, counter 45 is a conventional wrap-around counter with a four-bit output signal CB0-CB3, and count bus 47 is four bits wide. Signal EN is input to switching circuit 49 and to an inverter 51. Switching circuit 49 is coupled to receive an output signal ENN of inverter 51.

Signal RASBP is input to a fuse circuit 52. An output signal of fuse circuit 52 is supplied by fuse bus 54 to switching circuit 48. Preferably, fuse circuit 52 outputs a four-bit signal FB0-3 having the binary value 1,0,0,0, and fuse bus line 54 is four bits wide.

Referring to block 35, switching circuit 49 supplies an output signal via a bus 33 to an input of a predecoder circuit 56. Preferably, switching circuit 48 has a four-bit output signal COUNT0-3, and count bus 33 is four bits wide. Predecoder circuit 56 supplies an output signal via a trim bus 58 to a reference voltage generator circuit 60. Preferably, predecoder circuit 56 outputs an eight-bit signal TRIM0-7, and trim bus 58 is eight bits wide. Reference voltage generator circuit 60 is coupled to receive an external voltage VCCEXT. Circuit 60 supplies an output signal VREF to an input of a stress circuit 61.

A VDIVIDE circuit 62 is coupled to line 41 of an external voltage generator 68. VDIVIDE circuit 62 provides second voltage comparator 66 a signal VDIVIDE via a line of bus 37 to both voltage comparators 64 and 66. An output signal VREFP of stress circuit 61 is coupled in parallel to inputs of first and second voltage comparators 64 and 66 (block 39) via a line of bus 37. Alternatively, the voltage down converter may be implemented without the stress circuit 61. Reference voltage generator circuit 60 would have its output signal VREFP supplied directly over bus 37 to both voltage comparators 64 and 66. First voltage comparator 64 is coupled to receive signal RASBP. It is also coupled to receive an output voltage VDIVIDE of circuit 62. Moreover, second voltage comparator 66 also is coupled to receive the output voltage VDIVIDE of circuit 62.

Internal voltage generator 68 is coupled to receive an output signal NAVDCA from first voltage comparator 64. It also is coupled to receive an output signal NAVDCB from second voltage comparator 66. Internal voltage generator 68 outputs an internal voltage VCCINT on line 41.

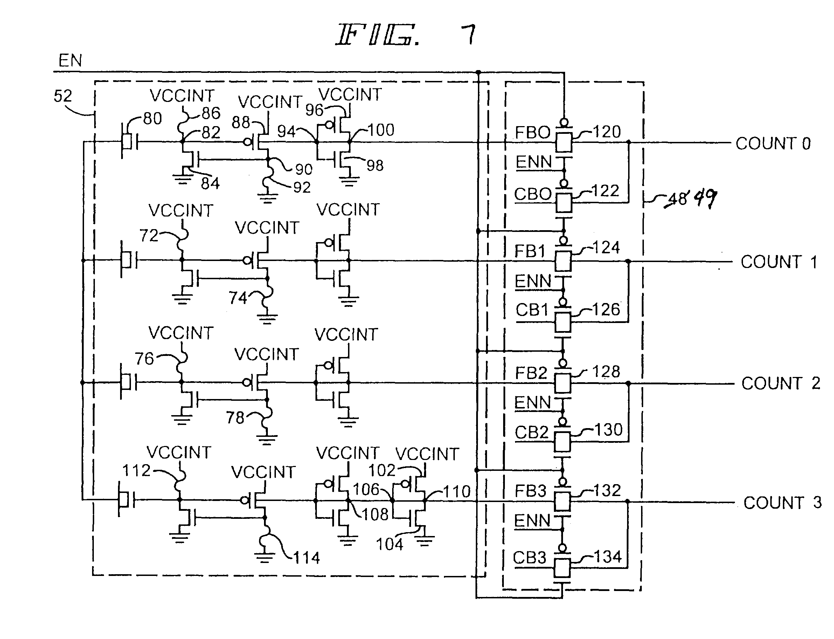

Fig. 7 shows a detailed diagram of fuse circuit 52 and switching circuit 48. The circuit configuration of fuse circuit 52 will be explained in connection with one of its output signals FB0. (Other output signals of circuit 52 are FB1, FB2 and FB3). Referring to a block 52, signal RASBP is coupled to an electrode of a capacitor 80. Another electrode of capacitor 80 is coupled to a node 82. Node 82 is selectively coupled to a second power supply, such as ground, through a source-drain path of a transistor 84. Node 82 is fuse coupled to internal voltage VCCINT through a first fuse 86. Node 82 is coupled to a gate electrode of a transistor 88.

A gate electrode of transistor 84 is coupled to a node 90. Node 90 is fuse coupled to the second power supply via a second fuse 92. Node 90 is selectively coupled to internal voltage VCCINT through a source-drain path of a transistor 88.

Node 82 is coupled further to a node 94. Node 94 is coupled to gate electrodes of transistors 96 and 98. Transistors 96 and 98 function as an inverter having an output node 100. Node 100 conducts a fuse bit signal FB0 corresponding to a least significant digit of the fuse circuit 52 output signals FB0-3.

Circuitry to generate fuse bits FB1 and FB2 is identical to the circuitry described above for generating fuse bit FB0. Circuitry to generate fuse bit FB3 preferably contains the same components as the circuitry for the other fuse bits, but also contains an additional inverter formed by transistors 102 and 104. Circuitry for generating fuse bit FB3 also includes a node 106 that is coupled to a node 108. Node 108 has an analogous function to node 100. Node 106 is coupled to gate electrodes of transistors 102 and 104. An output node 110 is selectively coupled to internal voltage VCCINT through a source-drain path of transistor 102. Node 110 is selectively coupled to the second power supply through a source-drain path of transistor 104. Node 110 supplies fuse bit signal FB3.

The generation of the fuse circuit 52 output signal FB0-3 will be explained by describing the generation of output signal FB0. The voltage at node 82 is internal voltage VCCINT since fuse 86 couples node 82 to internal voltage VCCINT. Node 90 has a voltage equal to the voltage at the second power supply (e.g. VSS or ground) since fuse 92 couples node 90 to the second power supply. The internal voltage VCCINT at node 82 is supplied to the gate electrode of transistor 88, which does not turn it on since transistor 88 is preferably a p-channel transistor. Similarly, node 90 supplies a voltage VSS to the gate electrode of transistor 84, which does not turn on because it is an n-channel transistor. Therefore, node 82 maintains the internal voltage VCCINT.

Node 82 also supplies internal voltage VCCINT to node 94. Internal voltage VCCINT does not turn on p-channel transistor 96, but does turn on n-channel transistor 98. Turned on transistor 98 couples node 100 to the second power supply. Node 100 thus has a voltage VSS (i.e. ground voltage) that is supplied as first bit FB0.

If fuses 86 and 92 are blown (preferably either all or none of the fuses are blown for each bit), then nodes 82 and 90 are decoupled, respectively, from the internal voltage VCCINT and the second power supply. Nodes 82 and 90 are floating and now have an indeterminate voltage. This indeterminate voltage is supplied to transistors 96 and 98 via node 94. It is unknown what state transistors 96 and 98 will be in, and the state of output signal FB0 would be unknown.

To overcome this, signal RASBP is supplied to capacitor 80. While signal RASBP is inactive (high), node 82 will maintain its indeterminate state. After signal RASBP transitions to the active state (low), node 82 is pulled down to a maximum voltage of VSS through capacitor 80. The voltage at node 82 is supplied to transistor 88 which turns on. On transistor 88 couples node 90 to internal voltage VCCINT. The internal voltage VCCINT at node 90 is supplied to the gate of transistor 84, which turns on. On transistor 84 clamps node 82 to VSS.

The voltage VSS at node 82 is supplied to transistors 96 and 98 via node 94. Consequently, transistor 96 will be turned on and transistor 98 will remain off. On transistor 96 clamps node 100 to the internal voltage VCCINT to supply output signal FB0 as high. Circuitry for output signals FB1 and FB2 function the same way.

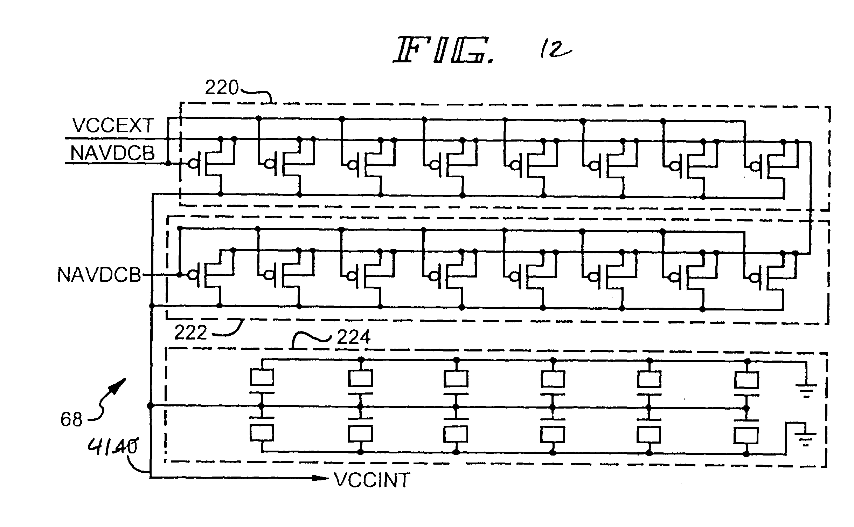

Circuitry for output signal FB3 includes node 108 that has the analogous function of node 100 for supplying first bit signal FB0. However, transistors 102 and 104 supply a voltage to node 110 that is the inverse of the voltage at node 108. Hence, when fuses 112 and 114 are not blown, the output signal FB3 at node 110 is high. When fuses 112 and 114 are blown, the output signal FB3 at node 110 is low. The circuit to generate output signal FB3 is configured to preferably provide a high output when the fuses 112 and 114 are not blown. This is done so that an internal voltage VCCINT initially generated will have an intermediate value, such as shown by 260 in Fig. 12, before testing begins.

Switching circuit 49 of Fig. 6 will be explained with reference to block 48 of Fig. 7. Block 49 includes complementary pass gates 120, 122, 124, 126, 128, 130, 132 and 134. Each of the complementary pass gates includes p- and n-channel transistors coupled together. The drain of the n-channel transistor is coupled to the source of the p-channel transistor to form an input terminal for each respective complementary pass gate. The source of the n-channel transistor is coupled to the drain of the p-channel transistor to form an output terminal for each respective complementary pass gate. Complementary pass gates are used so that either a full VSS or internal voltage VCCINT will pass without the threshold voltages of either transistor having an effect.

The gates of the p-channel transistors of complementary pass gates 120, 124, 128 and 132, and the gates of the n-channel transistors of complementary pass gates 122, 126, 130 and 134 are coupled to receive enable signal EN. The gates of the p-channel transistors of complementary pass gates 122, 126, 130 and 134, and the gates of the n-channel transistors of complementary pass gates 120, 124, 128 and 132 are coupled to receive inverted enable signal ENN.

The inputs of complementary pass gates 120, 124, 128 and 132 are coupled to receive output signals FB0-3, respectively, from fuse circuit 52. The inputs of complementary pass gates 122, 126, 130 and 134 are coupled to receive output signals CB0-3 via count bus 47, respectively, from counter 45 (as shown in Fig. 6).

Enable signal EN and inverted enable signal ENN, respectively high and low, will turn on complementary pass gates 122, 126, 130 and 134 to supply output signals CB0-3 as COUNT0-3. Enable and inverted enable signals respectively low and high will turn on complementary pass gates 120, 124, 128 and 132 to supply output signals FB0-3 as COUNT0-3. Complementary pass gates 120 and 122, 124 and 126, 128 and 130, and 132 and 134 function to respectively multiplex inputs CB0-3 with FB0-3 as output signals COUNT0, COUNT1, COUNT2 and COUNT3. Signals COUNT0-3 are conducted on bus 33 shown in Fig. 6 to predecoder circuit 56.

Output signals FB0-3 and corresponding output signals CB0-3 are shown in Table 1. Table 1 shows which of fuses 72, 74, 76, 78, 86, 92, 112 and 114 are to be blown ("1") to produce the desired output signals FB0-3.

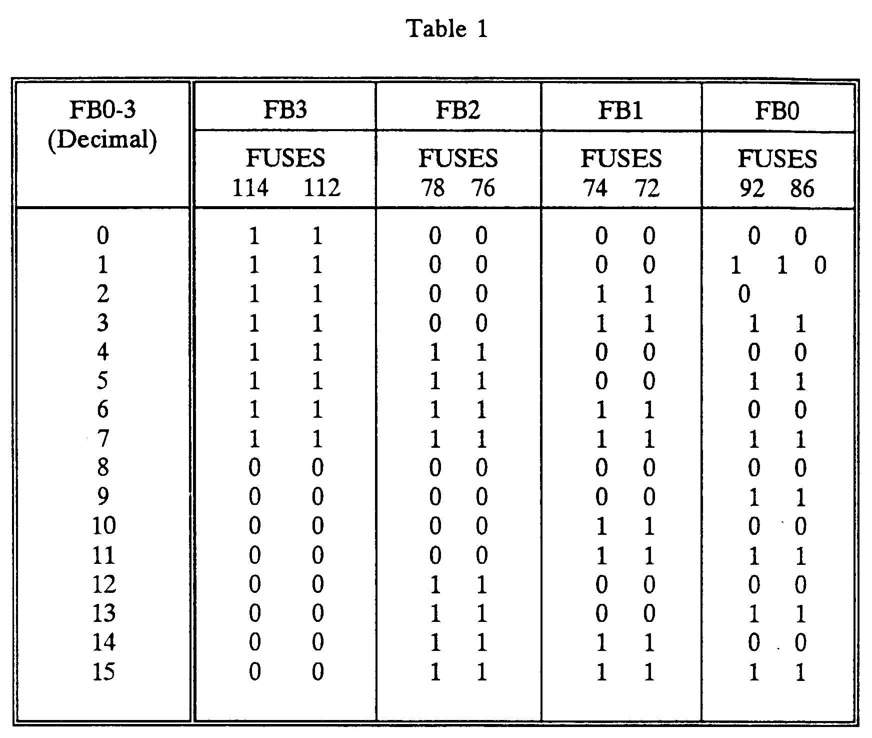

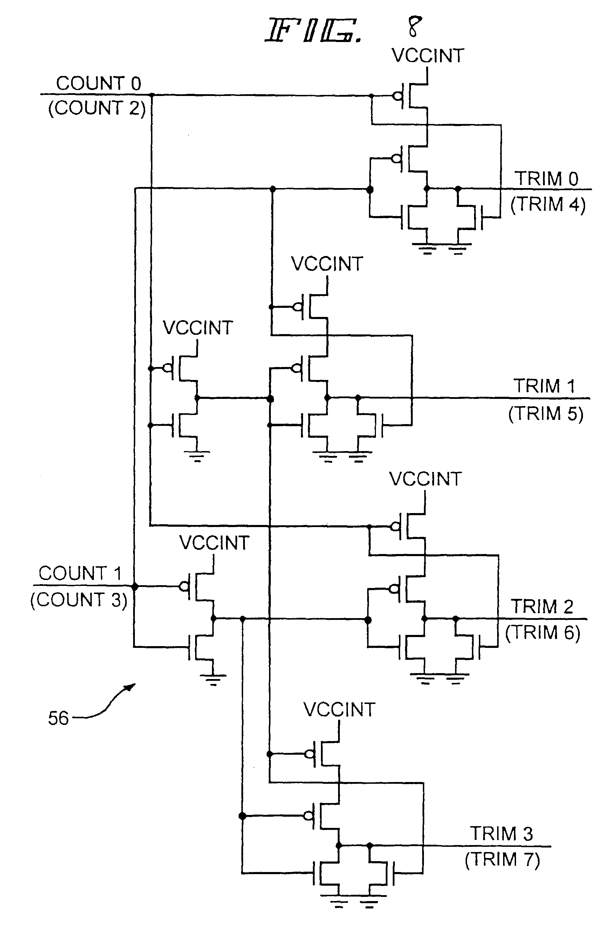

Predecoder 56 shown in Fig. 6 will be explained with reference to Fig. 8. Predecoder 56 has two identical circuits as illustratively shown in Fig. 5. One of the circuits is coupled to receive signals COUNT0 and COUNT1, and outputs signals TRIM0 to TRIM3. The other circuit receives COUNT2 and COUNT3, and outputs signals TRIM4 to TRIM7 as parenthetically shown in Fig. 8. Hence, circuits as shown in Fig. 8 decode the COUNT signals and generate TRIM signals in response thereto. The input-output characteristics of the circuit are shown in Table 2.

**Table 2**

| INPUT | | OUTPUT | | | |
|---|---|---|---|---|---|
| COUNT1 (COUNT3) | COUNT0 (COUNT2) | TRIM0 (TRIM4) | TRIM1 (TRIM5) | TRIM2 (TRIM6) | TRIM3 (TRIM7) |
| 0 | 0 | 1 | 0 | 0 | 0 |
| 0 | 1 | 0 | 1 | 0 | 0 |
| 1 | 0 | 0 | 0 | 1 | 0 |
| 1 | 1 | 0 | 0 | 0 | 1 |

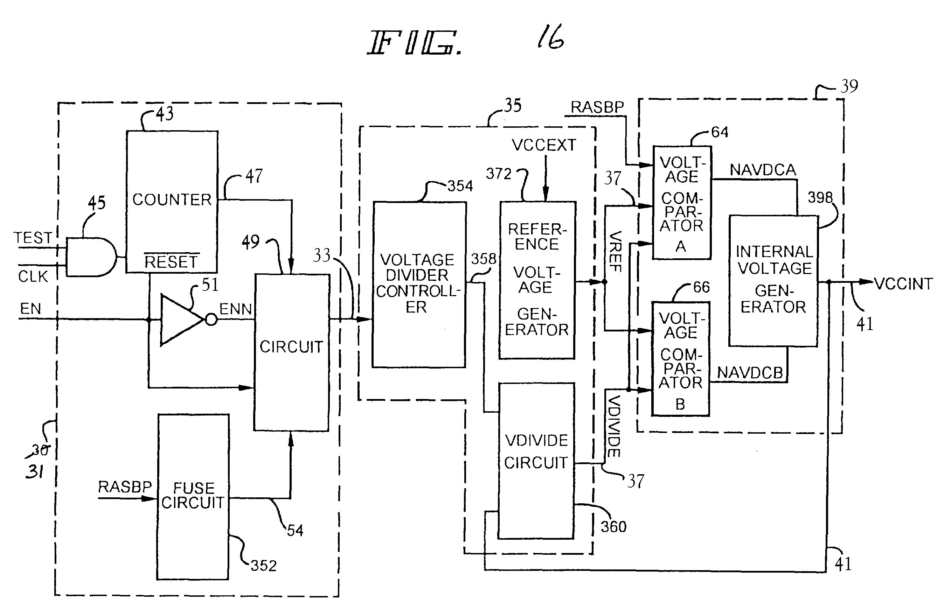

Note that fuse circuit 52 of Fig. 6 initially generates an output with no fuses blown (FB0-3 = 8 as shown in Table 1). This causes internal voltage generator 68 to output a preferred medium internal voltage VCCINT as shown by 260 in Fig. 15.

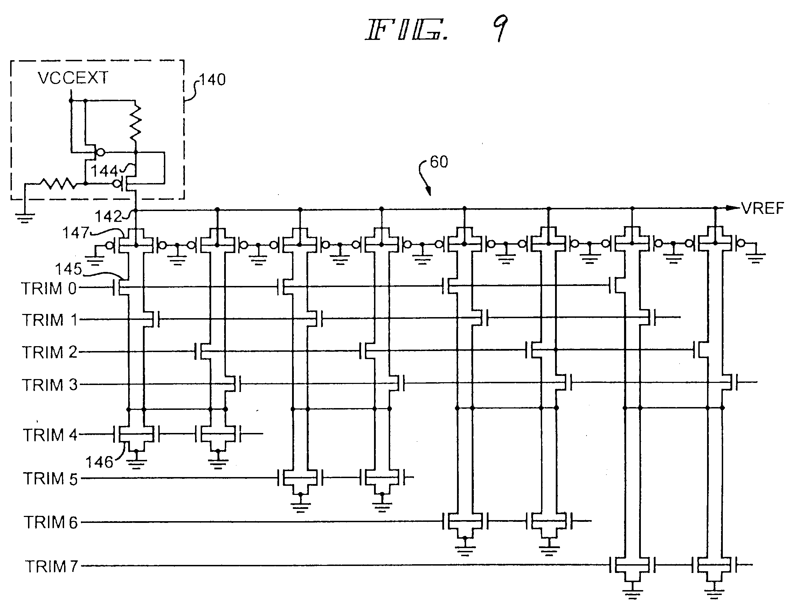

Fig. 9 shows the reference voltage generator circuit 60 of Fig. 6 in more detail. A block 140 includes transistors and resistors to provide a constant current source to a node 142. The constant current source will generate a corresponding voltage at node 142. The p-channel transistors shown in Fig. 6 preferably have their respective substrates coupled to a source providing a voltage equal to the voltage at node 142 to avoid latch-up and variation in the threshold voltage due to the body effect. For example, the substrate can be coupled directly to node 142. An additional transistor (not shown) may be coupled in parallel with transistor 144 in order to provide more current to node 142.

A circuit coupled to receive the constant current source from node 142 includes p- and n-channel transistors. Gates of the p-channel transistors are coupled to ground to maintain them in an on state. The n-channel transistors are coupled to receive respective signals TRIM0-7 from predecoder circuit 56 via trim bus 58 (shown in Fig. 3).

As seen in Table 2, preferably only two signals of signals TRIM0-7 are active at any one time. The two active signals activate their respective transistors in Fig. 6 to establish a path from a p-channel transistor to ground. A voltage VREF will be generated by the voltage drop from node 142 through the established path.

For example, when signals TRIM0 and TRIM4 are active (high), n-channel transistors 145 and 146 are turned on. Since a transistor 147 is configured to be on, a path is formed between node 142 and ground through transistors 145, 146 and 147. Current will flow through this path to generate and provide voltage VREF at node 142. Other transistors in Fig. 9 may have different dimensions and thus generate, when selected, a corresponding different voltage at node 142.

The stress mode circuit 61 shown in Fig. 6 preferably compares the voltage VREF supplied from reference voltage generator 60 to a voltage that is derived from VCCEXT. The greater voltage of the two will be output as VREFP. The circuit for stress mode circuit 54 may include two differential amplifiers to compare voltages VREF and the derivative of VCCEXT, and selectively provide the greater voltage of the two as the output VREFP via switches responsive to the output of the differential amplifiers. The circuit also preferably includes two voltage dividers to provide the derivative of VCCEXT to the differential amplifiers and to a switch.

Preferably, the stress mode circuit contains a power-up transistor in parallel with a transistor of one of the differential amplifiers. This transistor is used to power-up the stress circuit 61. It allows for current to bypass the transistor it is shunting during power-up. This allows the output of the differential amplifier having this transistor to initially output a high voltage. The high voltage is used to couple VREF to the output of stress circuit 61 to provide VREFP=VREF.

Stress circuit 61 may be omitted entirely. The output signal VREF of reference voltage generator circuit 60 may be coupled directly to the first and second voltage comparators 64 and 66 via a line of bus 37.

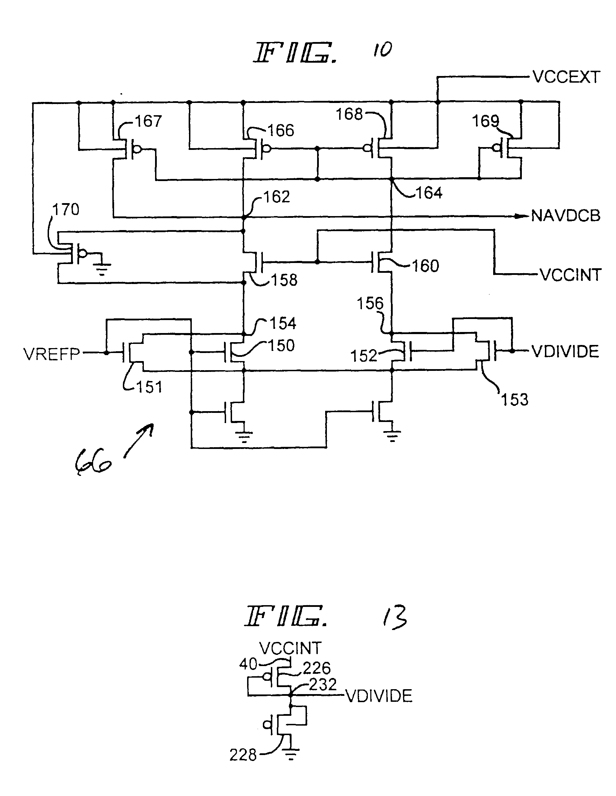

Referring to Fig. 10, which is a detailed schematic of second voltage comparator B 66, coupled to receive the output signal VREFP of stress mode circuit 61. In the preferred embodiment, second voltage comparator 66 comprises a differential amplifier coupled to receive VREFP and a voltage VDIVIDE. The preferred embodiment of the present invention is configured so that voltage VDIVIDE tracks VREFP. The p-channel transistors 166, 167, 168 and 169 have their respective substrates coupled to VCCEXT to avoid latch-up.

While VREFP > VDIVIDE, transistors 150 and 151 will have a greater current drive capability (i.e. allow more current to pass) than transistors 152 and 153. The greater current drive capability pulls a voltage at a node 154 lower than a voltage at a node 156. The lower voltage at node 154 creates a greater positive voltage difference between the gate and source electrodes of transistor 158 than the voltage difference between the gate and source electrodes of transistor 160. This greater voltage difference causes transistor 158 to conduct more current than transistor 160. A voltage at a node 162 will be pulled down to a voltage less than a voltage at a node 164. The voltage at node 162 is output as a signal NAVDCB. Signal NAVDCB is low when VREFP > VDIVIDE.

In the instance where VREFP < VDIVIDE, the current drive capabilities of transistors 150, 151 and 158 are less than the current drive capabilities of transistors 152, 153 and 160. The voltage at node 164 will be less than the voltage at node 162. The voltage at the gate electrode of transistor 166 will be the same as the voltage at node 164 since they are coupled together. The signal NAVDCB will be pulled high.
Transistor 170 is used as a power-up transistor for the circuit in Fig. 10. When powering up the preferred embodiment of the present invention, transistor 170 allows current to bypass transistor 158. This pulls the voltage at node 162 lower than the voltage at node 164. If transistor 170 were not used, upon power-up the voltage at node 162 and voltage of signal NAVDCB would be unknown. The preferred embodiment of the present invention requires NAVDCB to power up with a low voltage.

Additionally, transistor pairs 150 and 151, 152 and 153, 166 and 167, and 168 and 169 can be replaced by one transistor per pair. The sizes of the transistors can be varied to obtain the desired current through the circuit.

Transistors 158 and 160 in Fig. 10 are coupled between the other transistors to prevent a voltage drop VCCEXT-VSS across transistors 150, 151, 152 and 153, respectively. This is preferred since the present embodiment uses transistors of such small dimensions that a large voltage drop across the transistors (VCCEXT-VSS) may cause punch through or gated diode breakdown.

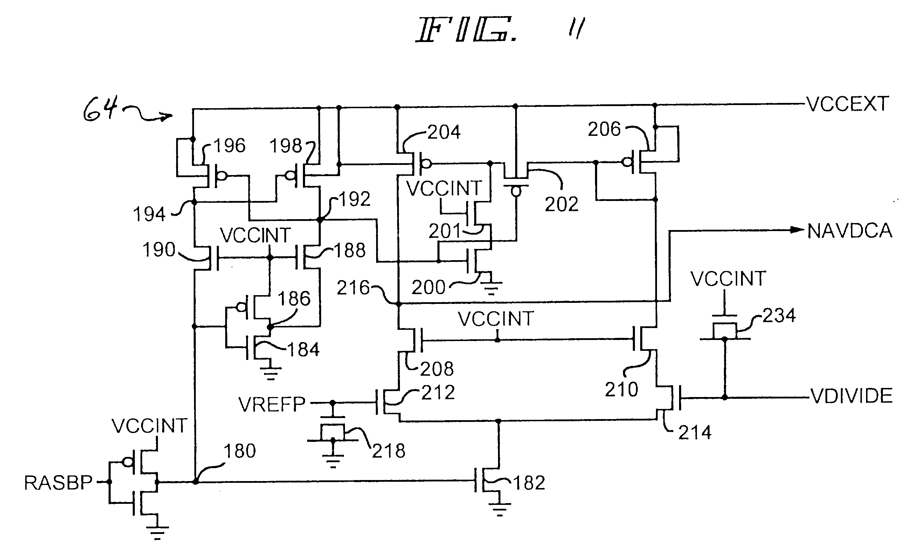

First voltage comparator 64 of Fig. 6 will be explained by referring to Fig. 11. The circuit of Fig. 11 is coupled to receive signal VREFP, signal VDIVIDE and signal RASBP. Signal RASBP enables the circuit when there is a heavy current demand, such as a read of a memory. Signal RASBP, active low, is preferably generated by the user in response to this demand. P-channel transistors 196, 198, 202, 204 and 206 have their respective substrates coupled to their respective source electrodes to avoid latch-up.

A voltage at a node 180 is high when signal RASBP is active (low). Transistors 182 and 184 are turned on. A node 186 is pulled low through the source-drain path of transistor 184. The voltage difference between the gate and source electrodes of transistor 188 is greater than the voltage difference between the gate and source electrodes of transistor 190. Transistor 188 will have a greater current drive capability than transistor 190 which will pull down a voltage at node 192. A voltage at node 194 is greater than the voltage at node 192 since transistor 190 has less current drive capability than transistor 188. Additionally, the voltage at node 194 will be greater than the voltage at node 192 since the voltage at the gate electrode of transistor 196 equals the voltage at node 192 (the voltage at node 192 is less than the voltage at node 194). Thus transistor 196 will pass more current and node 194 will be pulled towards a voltage VCCEXT.

Transistor 198 will not be passing much current since the voltage difference between its gate and source electrodes is greater than that of transistor 196. Therefore, the voltage at node 192 will be further pulled towards ground. The low voltage at node 192 turns off transistor 200. The low voltage at node 192 turns on transistor 202 to couple the gate electrodes of transistors 204 and 206 together.

Transistors 182, 204, 206, 208, 210, 212 and 214 form a differential amplifier. This differential amplifier operates as explained above for the Fig. 10 differential amplifier. A voltage at a node 216 decreases when VREFP > VDIVIDE and increases when VREFP < VDIVIDE. A signal NAVDCA follows the voltage at node 216. Transistors 208 and 210 are used to insure that there is not a large voltage drop, such as 5V, across any one transistor. This will eliminate any punch through.
While RASBP is inactive (high), its inverted signal at node 180 is low to turn off transistor 182. Off transistor 182 disables the differential amplifier. Node 180 is also coupled to an inverter having an output node 186, so when RASBP is high, node 186 is also high. The high voltage at node 186 turns off transistor 188 because both the gate and source electrode of transistor 188 have the same voltage. Transistor 190 is on, which pulls node 194 low. The voltage at node 194 is supplied to the gate of transistor 198 to increase the current drive capability of transistor 198 (i.e. render it more conductive). This in turn will pull the voltage at node 192 high. When the voltage at node 192 is high, it turns off transistor 202 to decouple the gate electrodes of transistors 204 and 206 from one another. The high voltage at node 192 also turns on transistor 200 which pulls the gate electrode of transistor 204 to ground.

The low voltage at the gate of transistor 204 makes it more conductive and hence increases its current drive capability. The voltage at node 216 and output signal NAVDCA are pulled high. Transistor 202 is used so that when RASBP is inactive, the low voltage at the gate electrode of transistor 204 is not supplied to the gate electrode of transistor 206. If this occurred (i.e. transistor 204 is either on or not used), transistor 206 would have an increased current drive capability. Current from VCCEXT would pass through transistors 206, 204 (if used), 201 and 200 to ground. This current would be wasted and would decrease power efficiency.

A capacitor 218 has a first terminal coupled to the gate electrode of transistor 212. This first terminal is coupled to receive voltage VREFP. A second terminal of capacitor 218 is coupled to the second power supply (e.g. ground). Capacitor 218 is used to maintain voltage VREFP substantially stable at the gate electrode of transistor 212.

Because of the structure of transistor 212, there are parasitic capacitances between the gate electrode and the source and drain electrode, respectively. The gate electrode is capacitively coupled to the source and drain electrodes. When the voltage at either the drain or source electrode changes, the capacitive coupling tries to change the voltage at the gate electrode. To counter this capacitive coupling effect, capacitor 218 is made sufficiently larger than either parasitic capacitance. The voltage VREFP will then remain substantially stable.

Fig. 12 shows the internal voltage (VCCINT) generator 68. A block 220 illustratively includes multiple p-channel transistors. These transistors are controlled by signal NAVDCA, which is coupled to their gate electrodes. They are inactive in stand-by mode to insure low power consumption. When there is a demand for current, these transistors become active and provide the extra current responsive to the signal NAVDCA. The p-channel transistors in Fig. 12 preferably have their respective substrates coupled to VCCEXT to avoid latch-up.

A block 222 illustratively includes other p-channel transistors which are controlled by signal NAVDCB. These transistors are always active when the chip is powered up.

A block 224 illustratively includes multiple capacitors connected in parallel to store charge. The charge is supplied to any circuit coupled to receive internal voltage VCCINT.

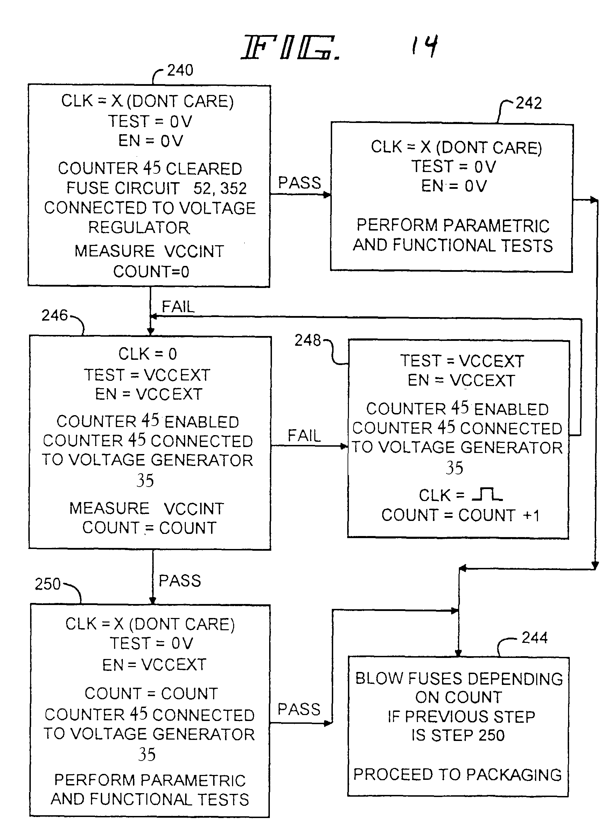

Referring to Fig. 13, transistors 226 and 228 are supplied with current from blocks 220 and 222 of Fig. 12. Internal voltage VCCINT is provided at a source electrode of transistor 226. Transistors 226 and 228 create a voltage divider circuit which provides voltage VDIVIDE at a node 232 to substantially maintain internal voltage VCCINT constant.

When internal voltage VCCINT changes magnitude, voltage VDIVIDE follows. However, because of long channel lengths needed to have low stand-by current of transistors 226 and 228, voltage VDIVIDE will not change as quickly as internal voltage VCCINT. To overcome this slow response, Fig. 11 shows a capacitor 234 coupled between internal voltage VCCINT and voltage VDIVIDE. When internal voltage VCCINT changes, capacitor 234 initially forces voltage VDIVIDE to change the same amount as that of internal voltage VCCINT. Subsequently, transistors 226 and 228 (as shown in Fig. 13) adjust voltage VDIVIDE to its new voltage.

An overview of the operation of the Fig. 6 embodiment is as follows. Signals TEST and CLK are gated together to increment the output of counter 45 as determined by a user. Switching circuit 49 will couple either outputs of counter 45 or fuse circuit 52 as COUNT0-3 to predecoder circuit 56 as input signals. The coupling is responsive to the state of signal EN, also determined by the user.

Predecoder circuit 56 decodes the input signals (COUNT0-3) and supplies the decoded signals (TRIM0-7) to reference voltage generator circuit 60. Reference voltage generator circuit 60 uses the decoded signals to generate a corresponding reference voltage VREF.

Reference voltage generator circuit 60 supplies the reference voltage VREF to stress circuit 61. Stress circuit 61 outputs VREFP, which may be equal to the input reference voltage VREF. Or VREFP may be a voltage equal to a ratio of VCCEXT, which is preferably greater than the reference voltage VREF. Alternatively, stress circuit 61 may be omitted. In such a case, reference voltage generator 60 provides reference voltage VREF to both voltage comparators 64 and 66.

VREFP is supplied to both voltage comparators 64 and 66. These voltage comparators compare signal VREFP to signal VDIVIDE supplied by VDIVIDE circuit 62. Their respective outputs, NAVDCA and NAVDCB, will vary according to the comparison of VREFP and voltage VDIVIDE. Voltage VDIVIDE is used as feedback generated from internal voltage VCCINT which is output from the internal voltage generator 68. For example, when there is a large current demand on line 41 in Fig. 6, internal voltage VCCINT and voltage VDIVIDE will decrease. Decreased voltage VDIVIDE will cause the differential amplifiers in Figs. 10 and 11 (if on (RASBP=0)) to decrease the voltage of signals NAVDCA and NAVDCB. Decreased voltages of signals NAVDCA and NAVDCB will cause the p-channel transistors in blocks 220 and 222 in Fig. 11 to pass more current to line 41 to meet the current demand.

NAVDCA and NAVDCB are applied as inputs to internal voltage generator 68. Internal voltage generator 68 generates internal voltage VCCINT responsive to those inputs. Again, VDIVIDE circuit 62 outputs the voltage VDIVIDE to the first and second voltage comparators 64 and 66 to adjust signals NAVDCA and NAVDCB to provide for the current demands on line 41 and to maintain internal voltage VCCINT substantially constant.

Fig. 16 shows a second embodiment of the voltage down converter. Structures in this second embodiment that are the same as structures in the preferred embodiment have the same numbers and their explanations are not repeated. The second embodiment, like the first embodiment, conforms to Fig. 5. Signals TEST and CLK are input to a logic circuit or gate 43, preferably an AND gate or a logic gate with an AND function. An output of logic gate 43 is supplied to a clock input of a counter 45. Signal EN is coupled to a reset input of counter 45. An output signal of counter 45 is coupled by a count bus 47 to a switching circuit 49. Preferably, counter 45 is a conventional wrap-around counter with a four-bit output signal CB0-CB3, and count bus 47 is four bits wide. Signal EN is input to switching circuit 49 and to an inverter 51. Switching circuit 49 is coupled to receive an output signal ENN of inverter 51.

Signal RASBP is input to a fuse circuit 352. An output of fuse circuit 352 is supplied by fuse bus 54 to switching circuit 49. Preferably, fuse circuit 352 outputs a four-bit signal FB0-3 and fuse bus line 54 is four bits wide. Fuse circuit 352 has the same structure as fuse circuit 52 in Fig. 4 except transistors 102 and 104 are omitted. Initially (when no fuses have been blown), fuse circuit 352 outputs a 4-bit parallel signal having binary value 0,0,0,0.

Switching circuit 49 supplies signals COUNT0-3 via a count bus 32 to an input of a voltage divider controller 354. Preferably, switching circuit 48 has a four-bit output, and count bus 33 is four bits wide.

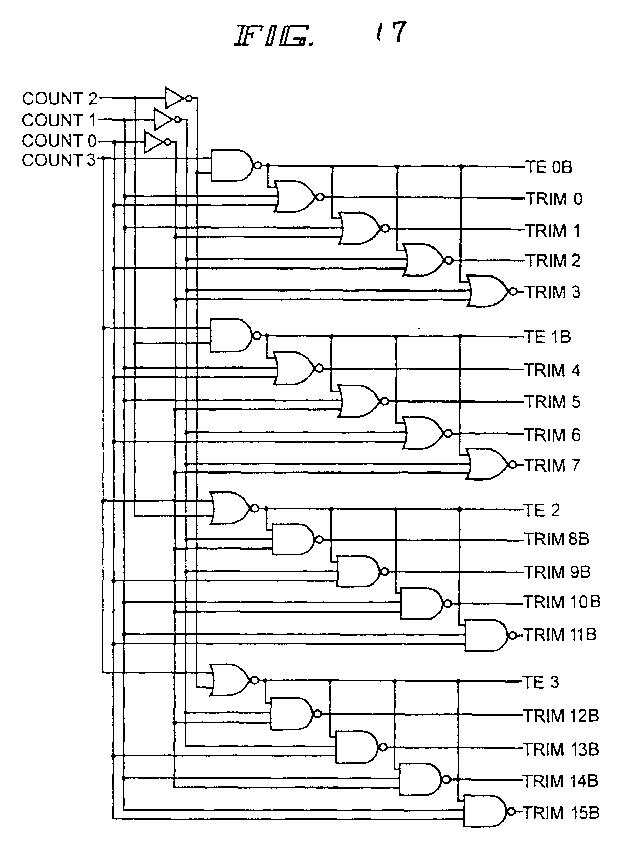

Controller 354 will be described by referring to Fig. 17. The four-bit output signal from switching circuit 49 is input to a logic gate array as shown in Fig. 17. The states of the four bits of signals COUNT0-3 are decoded by the logic gate array to render preferably only one of trim signals TRIM0-7 AND TRIM 8B-15B active, and one of the four trim enable signals TEOB, TE1B, TE2 and TE3 active. Trim signals TRIM0-7 and trim enable signals TE2-3 are preferably high when active. Trim signals TRIM 8B-15B and trim enable signals TEOB-1B are preferably low when active.

Preferably, voltage divider controller 354 outputs a twenty-bit signal (trim bus 358 is twenty bits wide) to a VDIVIDE circuit 360. It is preferred that only one of trim enable signals TE0B, TE1B, TE2 and TE3 is active at any one time. VDIVIDE circuit 360 is coupled to receive internal voltage VCCINT from a circuit 398 via line 41.

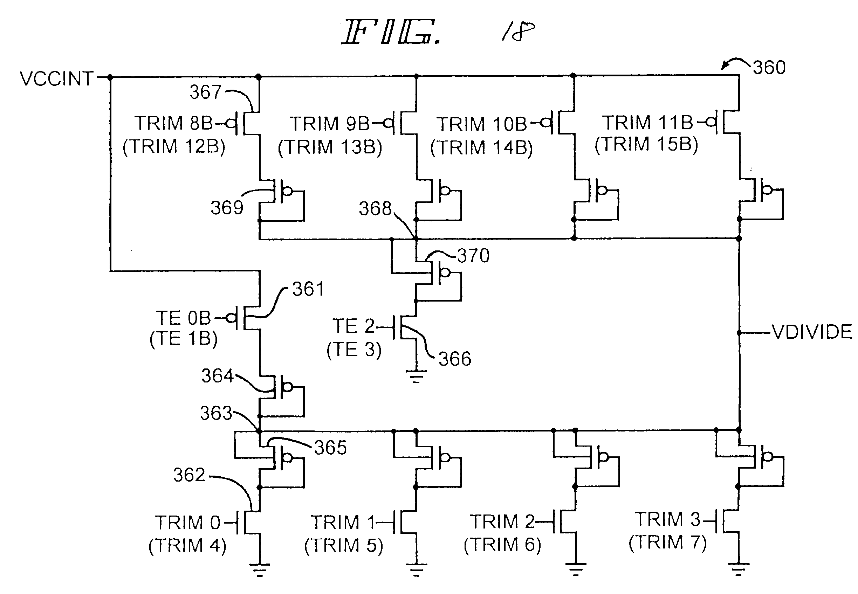

Referring to Fig. 18, VDIVIDE circuit 360 will be explained. VDIVIDE circuit 360 has two identical circuits as illustratively shown. One of the circuits is coupled to receive signals TRIM 0-3, TRIM 8B-11B, TE OB and TE 2. The other circuit receives TRIM 4-7, TRIM 12B-15B, TE 1B and TE 3 as parenthetically shown in Fig. 18.

The operation of Fig. 18 will be illustratively explained for active signals TE 0B and TRIM 0, and TE 2 and TRIM 8B. Active signals TE0B and TRIM0 (low and high, respectively) turn transistors 361 and 362 on. Transistors 364 and 365 are configured to be on. A voltage signal VDIVIDE will be generated at a node 363 by current passing through transistors 361, 364, 365 and 362. Voltage signal VDIVIDE is a ratio of internal voltage VCCINT and is preferably dependent mainly on the sizes of transistors 364 and 365. While TE 2 and TRIM 8B are active (high and low, respectively), transistors 366 and 367 are on. Transistors 369 and 370 are configured to be on. A voltage VDIVIDE will be generated at a node 368 by current through transistors 366, 367, 369 and 370. Voltage VDIVIDE is a ratio of internal voltage VCCINT and is preferably dependent mainly on the sizes of transistors 369 and 370.

VDIVIDE circuit 360 (circuit block 62 in Fig. 6) supplies voltage VDIVIDE via bus 36 to voltage comparators 64 and 66. Voltage comparators 64 and 66, which are the same as the ones used in the preferred embodiment (Figs. 10 and 11, respectively), are coupled to receive a reference voltage from reference voltage generator 372.

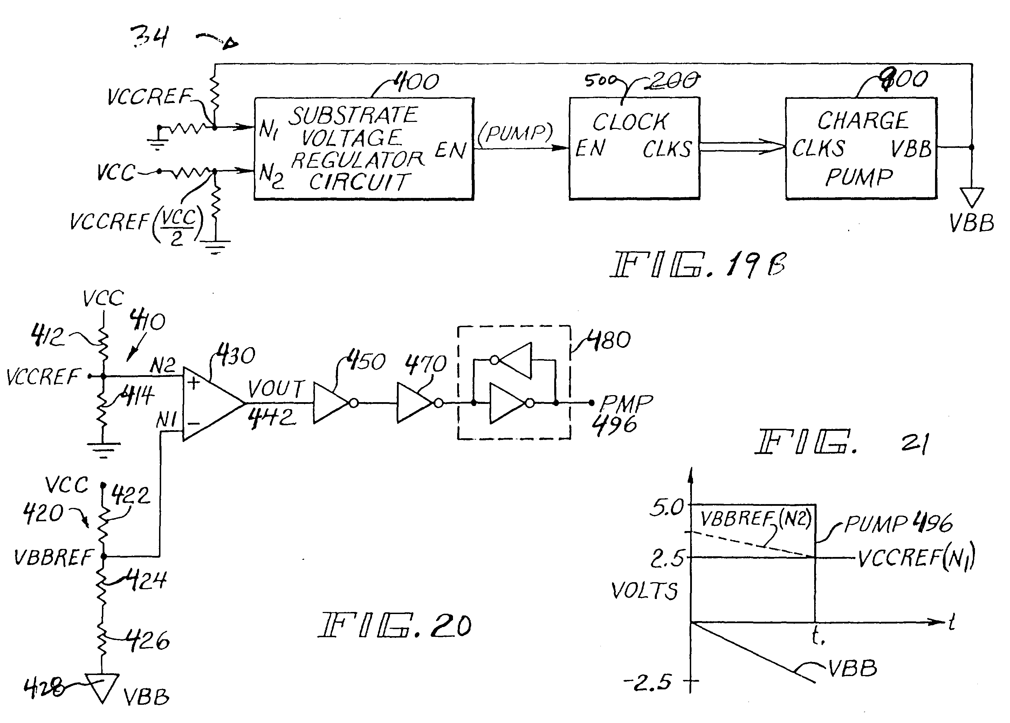

Fig. 19A shows reference voltage generator 372. The circuit including transistors 380 and 382, and resistors 384 and 386 is coupled to receive external voltage VCCEXT to provide a constant current to transistor 388. The current passing through transistor 388, which is configured to be on, will generate reference voltage VREF at a node 390. Transistors 382 and 388 may have varying sizes depending on the desired value of reference voltage VREF. Additional transistors may be respectively used in parallel to transistors 382 and 388 to achieve a desired reference voltage VREF.

First and second voltage comparators 64 and 66 (Fig. 6) provide signals NAVDCA and NAVDCB, respectively, to an internal voltage generator 398. VCCINT generator 398 includes the same structures as blocks 220, 222, and 224. Internal voltage generator 398 (circuit block 68 in Fig. 6) outputs internal voltage VCCINT, which is also provided to VDIVIDE circuit 360 (circuit block 62, Fig. 6).

An overview of the operation of the Fig. 15 embodiment is as follows. Signals TEST and CLK are gated together to increment the output of counter 45. Counter 45 is incremented at the user's discretion. Switching circuit 49 will couple either outputs of counter 45 or fuse circuit 352 to voltage divider controller 354 as input signals. The coupling is responsive to the state of signal EN which is set by the user.

Voltage divider controller 354 decodes the input signals COUNT0-3 to supply decoded signals TRIM0-7, TRIM8B-15B, TEOB, TE1B, TE2 and TE3 to VDIVIDE circuit 360. VDIVIDE circuit 360 uses the decoded signals to generate a corresponding voltage VDIVIDE which is a variable ratio of internal voltage VCCINT.

VDIVIDE circuit 360 supplies voltage VDIVIDE to both voltage comparators 64 and 66. These voltage converters compare VREF (provided by reference voltage generator 372) to voltage VDIVIDE. Voltage VDIVIDE is derived from internal voltage VCCINT. Their respective output signals NAVDCA and NAVDCB vary according to the comparison of VREF and voltage VDIVIDE. For example, when there is a large current demand on line 41, internal voltage VCCINT and voltage VDIVIDE will decrease. Decreased voltage VDIVIDE will cause the differential amplifiers in first voltage comparator 64 (if on) and second voltage comparator 66 to decrease the voltage of signals NAVDCA and NAVDCB. Decreased voltages of signals NAVDCA and NAVDCB will cause the p-channel transistors in internal voltage generator 398 to pass more current to line 41 to meet the current demand, and to maintain internal voltage VCCINT substantially constant.

Signals NAVDCA and NAVDCB are input to internal voltage generator 398. Internal voltage generator 398 and VDIVIDE circuit 360 generate internal voltage VCCINT responsive to signals NAVDCA and NAVDCB. VDIVIDE circuit 360 outputs voltage VDIVIDE to first and second voltage comparators 64 and 66 to adjust signals NAVDCA and NAVDCB to provide for the current demands at line 41.

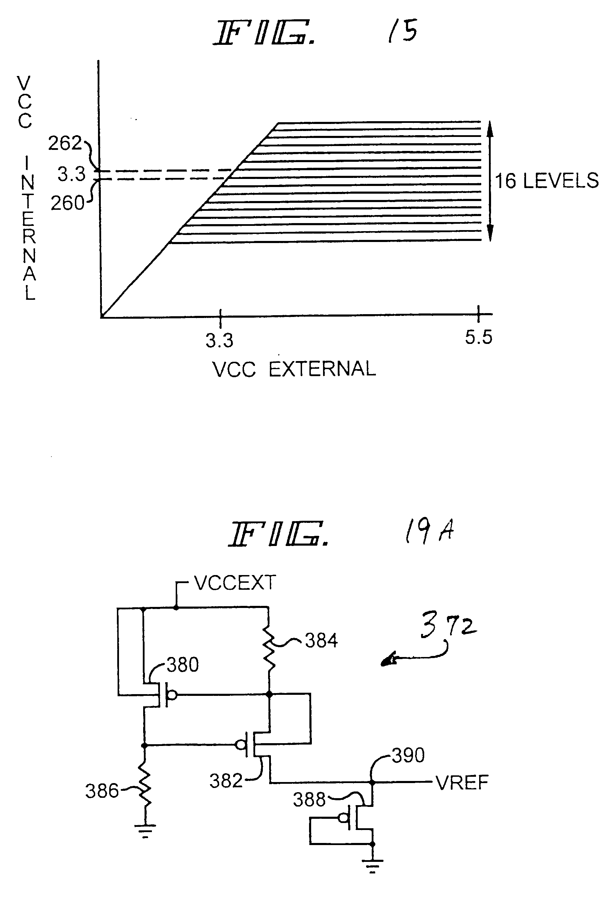

A detailed description of the use of the Fig. 5 will now be explained by referring to Fig. 14. Fig. 14 represents a flow chart for a general chip production testing procedure. Block 240 indicates that signal CLK is in a "don't care" state. Signals TEST and EN are inactive (low). Counter 45 (Figs. 6 and 16) is cleared by low signal EN. Low signal EN enables switching circuits 49 and 348 (shown in Fig. 6 and 16, respectively) to provide the output of fuse circuit 52 and 352, respectively.

Internal voltage VCCINT is generated responsive to the output of fuse circuit 52 and 352. Internal voltage VCCINT is measured as required by block 240. If internal voltage VCCINT is the target internal voltage for a tested die, then the test proceeds to a block 242. There, the die on the wafer is subjected to parametric and functional testing. Parametric testing includes measuring standby and active current, for example. Functional testing may include testing the timing of the die, and writing and reading logic states to and from an array. If this testing is successful, the test proceeds to a block 244. Since internal voltage VCCINT has been measured to be the target voltage, no fuses need to be blown. Subsequently, the wafer proceeds to be diced, and the dies packaged. If any die fails the parametric or functional testing, the die is marked and discarded.

If internal voltage VCCINT is not the target internal voltage (block 240), then the test proceeds to a block 246. There, signal CLK is inactive (low), and signals TEST and EN are active (high). Active signal TEST enables the counter by allowing signal CLK to pass through logic gate 31. Active signal EN causes switching circuits 49 and 348 to stop providing the output of fuses circuits 52 and 352. Switching circuits 49 and 348 provide the output of counter 45. Active signal EN also allows the counter to be incremented.

An internal voltage VCCINT is generated in response to the output of counter 45. Internal voltage VCCINT is measured to determine if it is the target internal voltage. If it is not the target internal voltage, then the test proceeds to a block 248.

At block 248, signal CLK is pulsed active to preferably increment counter 45 by one. The incremented counter 45 output causes a higher internal voltage VCCINT to be generated as shown by block 248 in Fig. 14. Then the test returns to block 246 to test if internal voltage VCCINT is the target internal voltage. If it is not the internal voltage, then the test proceeds to block 248 to increment counter 45. This is done until internal voltage VCCINT is the target internal voltage.

Once internal voltage VCCINT obtains the target internal voltage, the test proceeds to a block 250. There, signal CLK is in a "don't care" state. Signal TEST is inactive (low) which disables the counter 45 from incrementing. Signal EN remains active (high) to keep switching circuits 49 and 348 providing the output of counter 45. The dies are subjected to parametric and functional testing. If the dies fail these other tests, they are discarded or otherwise handled.

If the dies pass these tests, then the test proceeds to a block 244. The fuses in fuse circuits 52 and 352 are blown to maintain the output of switching circuits 49 and 348 corresponding to the count that generates the target internal voltage VCCINT. Switching circuits 49 and 348 are controlled to output signals FB0-3 from fuse circuits 52 and 352. Then the wafer is diced, and the resulting dies are packaged. If the dies were in an initial phase of testing to determine the target internal voltage VCCINT, and if the die fails the parametric testing in block 242, the flow chart may proceed to block 246. Here, counter 45 is incremented until a target internal voltage VCCINT is discovered.

Another benefit of the preferred embodiment of the present invention is that the target internal voltage VCCINT is achieved by using counter 45. A prior art generator integrated on a wafer requires the tester to remove the wafer and configure the fuses to generate the next internal voltage. Then, the tester must return to the testing station to measure the internal voltage. This process may be repeated several times to obtain the desired internal voltage. This slows down the manufacturing process. Using the preferred embodiment obviates the need to remove the wafer to adjust the internal voltage. The tester merely increments the counter.

Once the internal voltage is achieved, the wafer is then fully functionally tested. If the prior art generator is integrated on the wafer, and the wafer is determined to have sensitivity to that internal voltage VCCINT, the tester may or may not be able to trim the internal voltage further, depending on which fuses were blown. If the wafer is integrated with the preferred embodiment of the present invention, then the tester can adjust the counter so that the internal voltage is adjusted to another value to further the functional tests. Not only is manufacturing time and testing time saved, but a higher yield of the wafers may be achieved.

It will be understood that in the adjustment or trim process, a first internal voltage VCCINT can be generated using a first count signal. The manufacturer may have predetermined that the target internal voltage VCCINT is some particular voltage. Then a simple comparison is made to see whether the first internal voltage VCCINT is near enough to the predetermined voltage to be accepted. If not, adjustment is made by changing the count to produce a second internal voltage VCCINT.

Alternatively, a range of internal voltage VCCINT values may be potentially acceptable and the die or chip can be fully tested at each internal voltage VCCINT value resulting from the count signal. Then the count signal can be adjusted and a second set of fully functional tests can be performed. This process is reiterated and then one internal voltage VCCINT (with the corresponding count) can be selected and locked into place.

Thus, it will be appreciated that the voltage converter 39 output internal voltage VCCINT is trimmed without blowing any fuses. Instead, a corresponding condition is temporarily and adjustably provided. After each single adjustment of the temporary circuit (the counter configuration), a test is performed. The counter may be advanced in single counts or in multiple counts, as desired. The counts may advance and they retreat (if an up-down counter were used) to focus or converge on whichever count leads to the optimum internal voltage VCCINT. After the best count, or a count that produces acceptable results has been determined, the temporary circuit is replaced with a permanent one that corresponds thereto.

Counter 45 and fuse circuits 52 and 352 may have more or fewer outputs. It is preferred that the maximum count value of counter 45 is "15". Incrementing the counter 45 when its output is "15" will force counter 45 to roll over to zero. This is a useful feature since the user can roll over the counter 45 if it is incremented too far without having to also set EN to reset counter 45.

Other embodiments may not have predecoder 47 or voltage divider controller 354, but instead directly couple the output signal of switching circuits 49 and 348 to reference voltage generator circuit 52 and voltage divider 360, respectively.

It should be appreciated that adding a counter to a voltage comparator requires little chip area because it utilizes only a counter, a switch circuit, and some logic gates. This calls for only a minimal size increase.

Capacitors illustratively shown in the figures are preferably transistors configured with their respective source and drain electrodes coupled together to form one terminal of the capacitor. The gate electrode forms the other terminal of the capacitor. The transistors illustratively shown in the figures may be manufactured to have different sizes to alter the current flow through them. Further, transistors may have other transistors coupled in parallel with them to provide extra current drive capability. These parallel transistors may be connected or disconnected during wafer fabrication.

It will be understood that either the voltage VREF or voltage VDIVIDE can be trimmed to provide the various internal voltages VCCINT.

### The Substrate Bias Generator

The substrate bias generation circuit 34 (Fig. 1) preferred for use in the present invention provides a voltage regulator having a self-timed circuit in place of an oscillator, therefore saving considerable power when in the standby mode. A DC regulator, which itself is designed to draw low current and consume low power, is the only circuit which is constantly running and consuming power. When the charge pump is not pumping, the current in the circuit can be less than a few microamperes. The DC regulator enables a self-timed clock circuit only when a substrate voltage V_{BB} is too high. The self-timed clock circuit controls a charge pump which pumps substrate voltage V_{BB} to a more negative value. This self-timed clock circuit drives the charge pump until V_{BB} has reached a desired level and the DC regulator signals it to stop. The clock circuit is self-timed because it ignores a signal to pump until the charge pump is ready to pump.

Turning first to Figure 19B, a block diagram shows the general structure of the oscillatorless substrate bias generator circuit of the present invention. A signal V_{BBREF} (which is proportional to the substrate voltage V_{BB}) is input to a voltage regulator 400. The V_{BBREF} signal is compared to a reference voltage VCC_{REF}, preferably ½VCC, to determine whether the substrate voltage V_{BB} has risen above a certain predetermined level (for example, approximately minus two (-2) volts). If substrate voltage V_{BB} has risen above that level, regulator circuit 400 enables a clock circuit 500. Clock circuit 500 generates clock signals which control a charge pump 900 which pumps electrons to V_{BB} (or draws current from V_{BB}) to lower the potential at V_{BB} to a desired level.

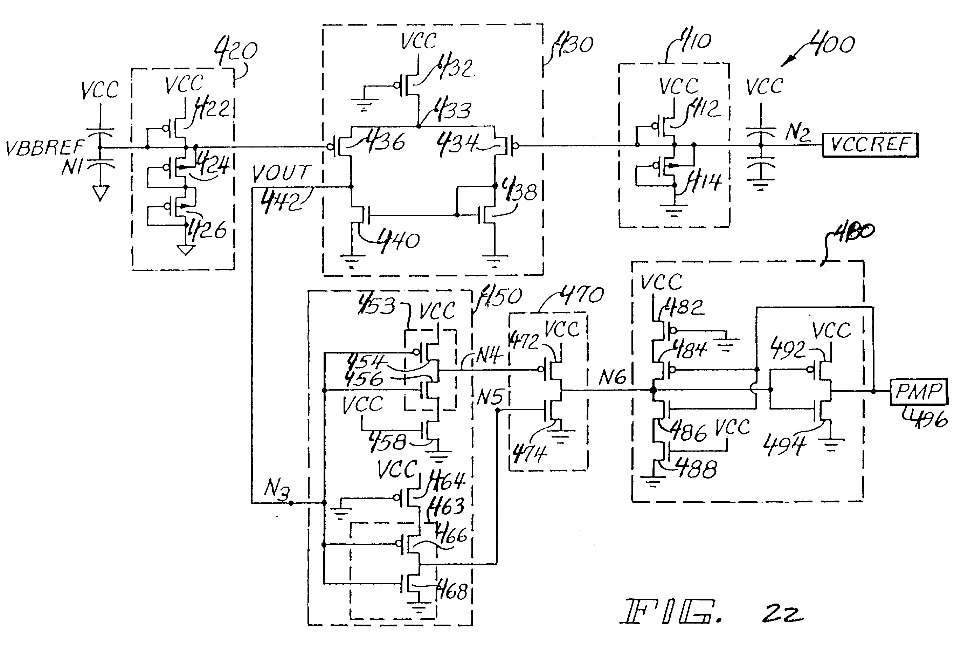

A simple schematic diagram is shown in Figure 20 to describe the operation of the substrate voltage regulator circuit 400 of Figure 19. As mentioned earlier, the substrate voltage regulator circuit monitors the substrate voltage V_{BB} to determine whether V_{BB} has risen above a desired level. A resistor network 420 comprising resistors 422, 424 and 426 is used to generate a voltage V_{BBREF} (which is proportional to the voltage at the substrate 428) at the negative input (node N1) of the differential amplifier 430. A second resistor network 410 comprising resistors 412 and 414 is used to generate a reference voltage VCC_{REF} at the positive input (node N2) of the differential amplifier 430.

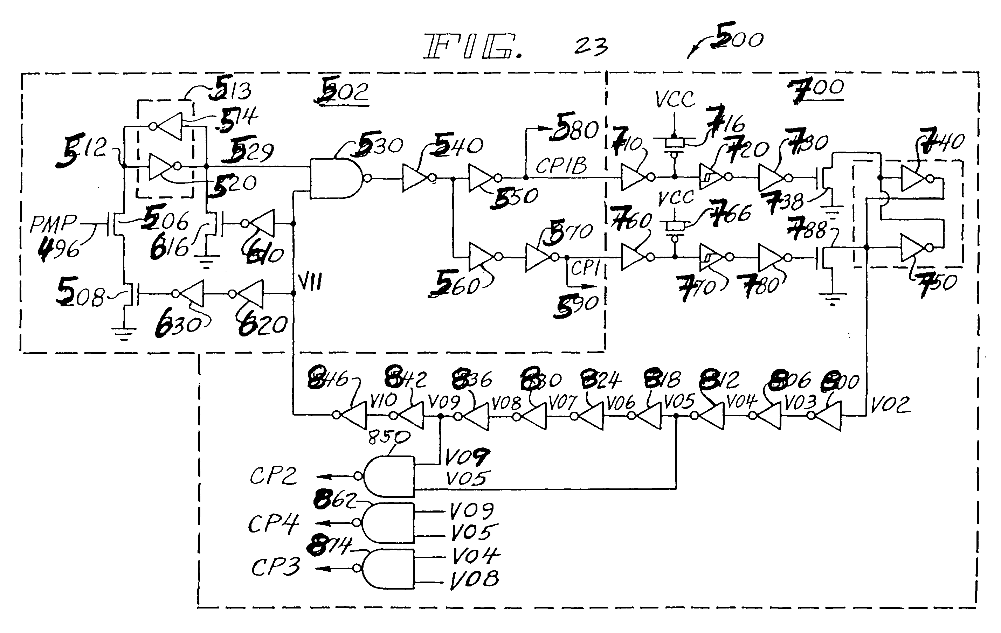

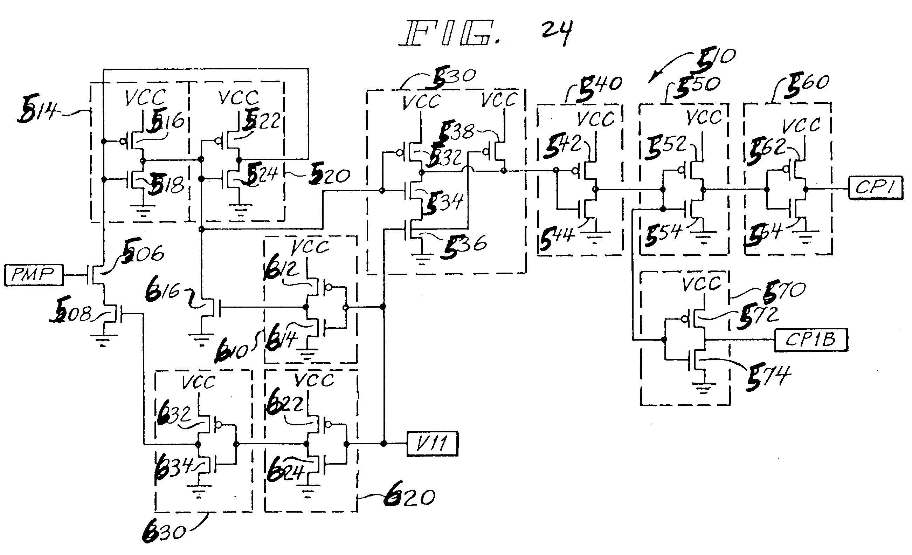

As will be shown in detail in the timing diagram in Figure 21, if the substrate bias voltage becomes too positive, V_{BBREF} will exceed VCC_{REF} and the comparator will output a low V_{OUT} signal 442. V_{OUT} 442 is passed through a series of inverters (450, 470 and 480 which will be discussed in detail in reference to Figure 22) to generate a pump signal 496. Therefore, when the V_{BB} signal is insufficiently negative, the substrate voltage regulator circuit 400 will generate a high pump signal 496 to activate clock circuit 500 and charge pump 900. Otherwise, a low pump signal 496 disables clock circuit 500, and both the clock and the charge pump remain off.

Figure 21 shows a timing diagram of the input and output signals of V_{BB} regulator 400, and specifically shows when the pump signal 496 changes between high and low signals to enable or disable clock circuit 500 and charge pump 900. Although the timing diagram of Figure 21 includes a 5 volt VCC, a 3 volt VCC is also contemplated in the present invention. Because VCC is fixed, the positive input VCC_{REF} to the differential amplifier is fixed at approximately at VCC/2 or 2.5 volts. However, V_{BBREF} is dependent on V_{BB}, and therefore may vary with the substrate voltage. When V_{BB} is initially at 0 volts, V_{BBREF} is at approximately 3.3 volts (assuming that resistances of 422, 424 and 426 are the same). Therefore, because V_{BBREF} is greater than VCC_{REF}, the output of differential amplifier 430 will be low, and pump signal 496 will be high, activating the charge pump. As V_{BB} is gradually decreased by pumping charge (electrons) to the substrate, V_{BBREF} will gradually drop. At a time t1, V_{BBREF} will drop below VCC_{REF}. Therefore, the output of the differential amplifier will now be high and pump signal 496 will be low, thereby turning off the clock circuit which the charge pump. When V_{BBREF} later rises above VCC_{REF}, the pump will again be turned on to lower the voltage of the substrate.

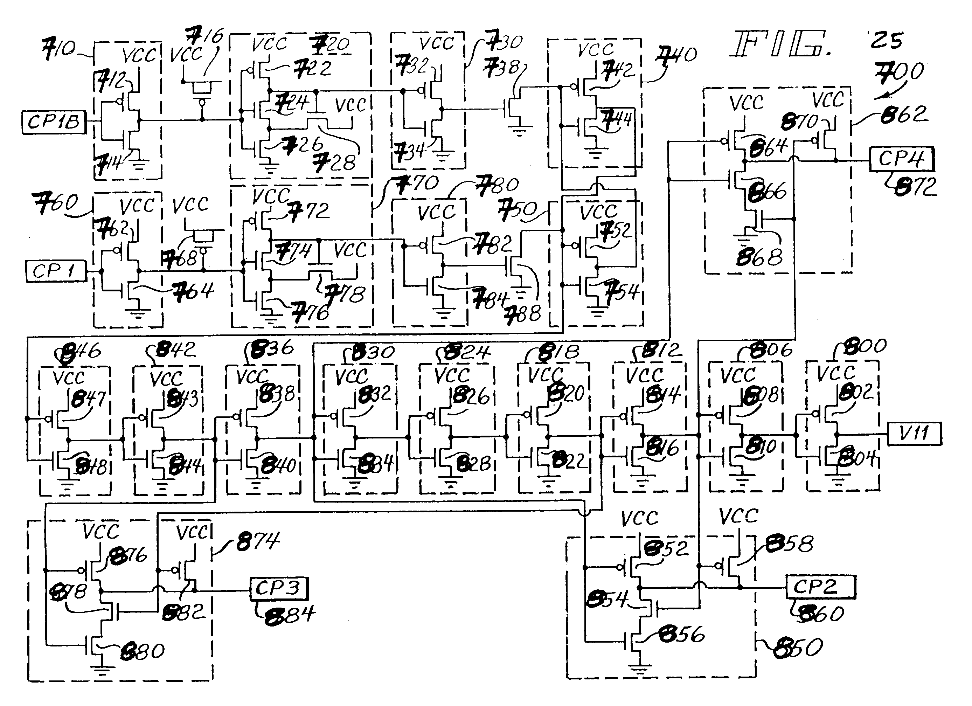

Having shown the general operation of the substrate voltage regulator circuit 400, additional features of the substrate voltage regulator circuit which reduce current loss and power consumption are shown in the detailed schematic diagram of Figure 22. Also, the devices shown in the schematic diagrams are those well known in the art (e.g. for example, transistor 424 of Figure 23 is a P channel enhancement type transistor with its substrate tied to its source). Also, all transistors are preferably enhancement type transistors, although depletion type transistors could be used.

In order to reduce power consumption in the voltage bias generator circuit, the voltage regulator circuit 400 of Figure 22 is designed to generally operate on low current and limit current loss in the circuit. In the preferred voltage regulator circuit, the resistor networks 410 and 420 include transistors configured as resistors (i.e. transistors having the gate tied to the source or drain). Because the current through the transistors is a function of the ratio of the channel width/length ratio, the channel lengths of these enhancement resistors are generally large to limit current through the transistor networks.

The differential amplifier circuit 430 preferably includes transistors 432-440 configured to compare VCC_{REF} with V_{BBREF} and to provide an output (V_{OUT}) signal 442. The operation of differential amplifier circuit 430 is well known in the art. The preferred dimensions of the transistors 432-440 of the differential amplifier circuit 430 are chosen to keep current in the circuit low, and therefore minimize power consumption. Specifically, the width/length ratio of the transistors of the differential amplifier circuit 430 is preferably kept small by selecting long channel lengths to limit the current flow. Although the specific design of differential amplifier circuit 430 is shown, other circuits which compare two signals to provide an output and limit current flow could be used within the scope of the present invention.

Although the long channel length of the transistors of the differential amplifier circuit limits the current flow, the circuit will generally react slowly and will output a slow changing signal 442 (i.e. a signal which does not have a sharp transition between low and high states). A slow changing signal can often lead to current loss in a circuit, particularly when input to a two transistor inverter. Specifically, both transistors of the inverter will be on for a certain period of time, leading to "through current" or "crow bar current" through the series of transistors. Therefore, there is often current loss from VCC to ground by way of the two transistors during the transition.

To compensate for the slow changing signal 442, inverters 450 and 470 and latch 480 are specifically designed to reduce the through current in the inverters and to output a pump signal 496 having a sharp transition. The switching time of transistors is generally dependent on the channel width/length ratio. Therefore, the channel widths and lengths can be chosen to establish when the transistors of the inverter will switch. Because the widths of the transistors in circuit 450 are the same, the switching time will be a function of their channel lengths. The channel lengths of the transistors of 454, 456, 464 and 466 of circuit 450 are chosen so that the voltages at nodes N4 and N5 (and therefore transistors 472 and 474 of circuit 470) switch at an appropriate time.

Specifically, when V_{OUT} signal 442 transitions from a high signal to a low signal to change the voltage at node N6 from high to low, it is beneficial to turn off transistor 472 before turning on transistor 474 to limit through current from VCC to ground in inverter 470. To accomplish the switching of the transistors of inverter 470 in this order, the length of transistor 466 is generally longer than that of transistor 454 to ensure that transistor 474 turns on after transistor 472 turns off.

In contrast, when V_{OUT} transitions from a low signal to a high signal, it is beneficial to turn off transistor 474 before turning on transistor 472 to limit through current from VCC to ground. The length of transistor 456 is generally longer than that of transistor 168 to ensure that transistor 472 turns on after transistor 474 turns off. Therefore, the selection of channel lengths of the transistors of inverter circuit 450 eliminate any path from VCC to ground in inverter 470 during either transition.

To further limit through current in the voltage regulator circuit, transistors 458 and 464 are added to inverter 450 to reduce any through current in inverters 453 and 463. Because of the current-limiting transistors 458 and 464 have long channel lengths, nodes N4 and N5 will not be pulled rapidly to ground and VCC, respectfully. Therefore, the path from VCC to ground will exist while driving transistors 472 and 474, but the current will be reduced in the series of transistors 454-458 and 464-468 by the long channel lengths of transistors 458 and 464.

Also, transistors 458 and 464 are selectively positioned to ensure that the timing of the switching of the transistors as described above is not affected. When node N3 is transitioning from high to low, it is preferable that the inverter 453 drive N4 high very quickly by turning on transistor 454 to shut off transistor 472. Therefore, current-limiting transistor 458 is added only to the n-channel side of the inverter 453 to limit the effect of transistor 458 on transistor 454. While current-limiting transistor 458 does effect the timing of driving node N4 low when node N3 transitions from low to high, the capacitive coupling of transistor 458 to node N4 is large enough to pull node N4 low enough to turn on transistor 472 at an appropriate time.

Similarly, when node N3 transitions from low to high, it is preferred that inverter 463 drive node N5 low very quickly by turning on transistor 168 to shut off transistor 474. Hence, the current-limiting transistor 464 is added only to the p-channel side of inverter 463 to limit the effect of transistor 464 on transistor 468. While current-limiting transistor 464 does affect the timing of driving node N5 high when node N3 transitions from high to low, the capacitive coupling of transistor 464 to node N5 is large enough to pull node N5 high enough to turn on transistor 474 at an appropriate time.

Finally, latch 480 is also included in the voltage regulator circuit 400 to maintain the output of the pump signal 496 during the period when neither transistor 472 nor transistor 474 of inverter 470 is driven (as discussed above to prevent through current). Pump signal 496 is fed back via line 495 to transistor network 482-488 to maintain the original voltage at node N6 until the state of node N6 changes when inverter 470 drives node N6.

In order to reduce the power consumption of the oscillator, latch 480 itself is designed to limit the through current while also providing a weak latch. Transistors 472 and 474 are generally small transistors (i.e. small widths and lengths) to limit the current required from inverter 450 to switch inverter 470. However, because of their size, they generally cannot drive a large capacitive load at node N6. Too large a capacitance at node N6 is undesirable because this capacitance will cause the voltage at the node to switch slowly. Therefore, a weak latch is provided at node N6 by selecting transistors 484 and 486 to have smaller widths and lengths, preferably on the order of 1-2 µm, to limit the capacitance at node N6.

However, because transistors 484 and 486 of the latch have widths and lengths which are about equal, they also have a large width/length ratio and drive greater current. Therefore, current-limiting transistors 482 and 488 are included. These transistors have long channel lengths (and therefore small width/length ratios) to limit the current in the latch 480 and reduce power consumption in the circuit.

Having generated a stable pump signal 496 in the voltage regulator circuit 400, a high pump signal 496 is used to activate clock circuit 500. Generally, clock circuit 500 generates signals which control charge pump 900. The first stage 502 of the clock circuit generates clock signals CP1 and CP1B, while the second stage 700 of the clock circuit receives signals CP1 and CP1B to generate signals CP2, CP3 and CP4. (It will be recognized that "B" stands for "bar" and denotes a complementary signal.) The signals generated by both stages of the clock circuit are used to drive the pump circuit 900. Preferably clock circuit 500 is a self-timed clock.

As will become apparent in reference to the pump circuit, the pump circuit operates on a two cycle principle: a pumping cycle and a precharge cycle. Therefore, the clock circuit must generate two sets of signals. While the clock circuit 500 generally operates in the same manner during both cycles, the circuit includes a feedback line to generate different signals during each cycle. The clock signals generated during the pump cycle will be described first, followed by the clock signals generated during the precharge cycle.

Referring to the clock circuit of Figure 23, signal V₁₁, a feedback input to the first stage 502, generally determines the cycle of the pumping circuit. In the initial state, the outputs of the clock circuit will be those present after a precharge cycle and when the circuit is waiting to receive a pump signal. Therefore, signal V₁₁ is high and transistor 508 is on, allowing the clock circuit 500 to receive the pump signal 496. When the pump signal 496 is low, the clock circuit and the current pump remain in the quiescent state until receiving a high pump signal.

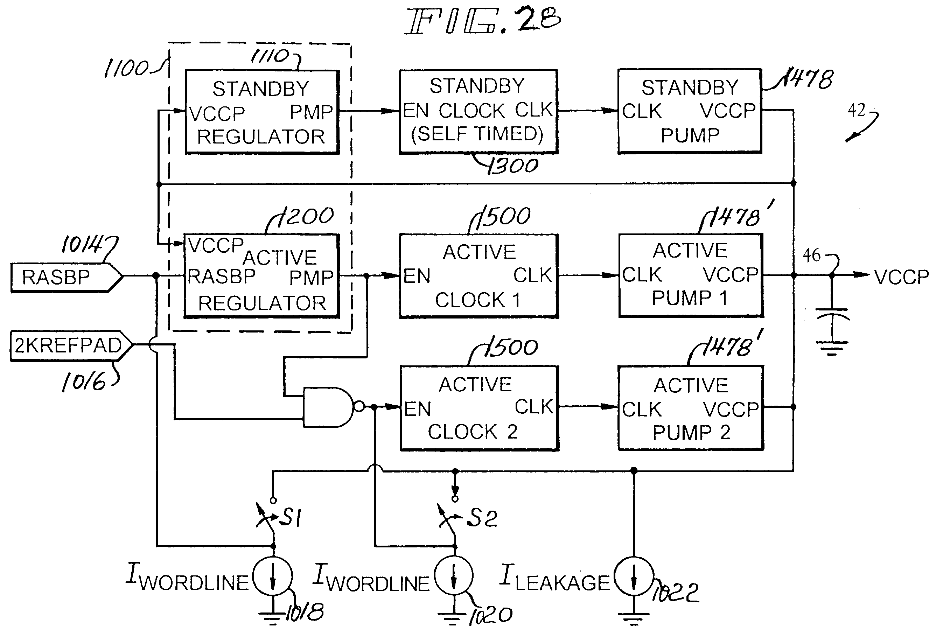

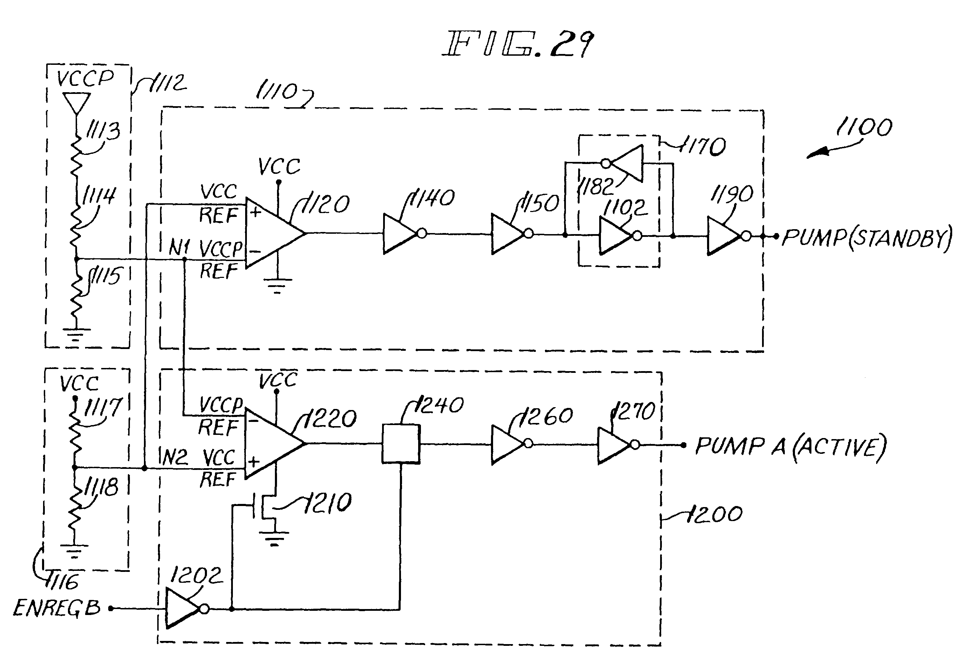

When pump signal 490 is high, transistor 506 is turned on to generate the clock signals during the pumping cycle. Node 512 at the input of latch 513 is pulled low and node 529 is pulled high when transistor 506 is turned on. Because both inputs to the NAND gate 530 are high, its output is low. Therefore, in the pumping cycle, output signal CP1 is high (after the output of the NAND gate passes through inverters 540, 560 and 570), and output signal CP1B is low (after output of the NAND gate passes through inverters 540 and 550). The function of the signals will be understood in reference to the operation of the pump circuit shown in Figure 26. These voltage signals generated by the first stage 502 of the clock circuit 500 are shown as a function of time in Figure 27 and will be further discussed in reference to the pump circuit.

In addition to driving the pump circuit, CP1 and CP1B are used to drive the second stage 700 of the clock circuit and generate signals CP2, CP3 and CP4. CP1B and CP1 are input into inverters 710 and 760. These inverters along with associated capacitors 716 and 766 are a part of the self-timing circuitry of the clock circuit and are used as delay circuits. Inverters 710 and 760 include transistors having long channels which, along with capacitors 716 and 766, set the delay. The delay is necessary to set the time periods T_{PUMP} and T_{PRECHARGE}, shown in the timing diagram of Figure 27, to adequately pump all the charge during both cycles of the charge pump.

The signals charging capacitors 716 and 766 are input into the Schmitt triggered inverters 720 and 770 respectively. As is well known in the art, a Schmitt trigger can change a slow moving waveform (such as the signals used to charge capacitors 716 and 766) into a waveform having a sharp transition. A latch circuit including inverters 740 and 750 is used to prevent the output from floating and to generate a stable output V02 when neither transistor 738 nor transistor 788 is driving the output V02.

The output of the latch is then transmitted through a series of inverters 800-846. These inverters generally provide delay and signal inversion for generating signals CP2, CP3 and CP4. Gates 850, 862 and 874 receive intermediate signals at various stages of the series of inverters to generate output signals CP2, CP4 and CP3, respectively. As is apparent from the circuit of Figure 23, CP2 and CP4 are identical signals. The need for identical signals will become more clear in the description of the pumping cycles of the pump circuit of Figure 26. Because NAND gate 874 is driven by signals which are separated by one additional inverter from the signals which drive NAND gates 850 and 862, CP2/4 and CP3 are non-overlapping active low signals which are 180° out of phase with each other. These non-overlapping signals are required (along with the CP1 and CP1B signals) to drive the pump circuit.

Because there is an odd number of inverters in the series of inverters 800-848, the feedback signal V11 is the inverted signal of the input V02 (and the initial signal V11). This feedback configuration of signal V11 provides the self-timed feature of the present invention. Specifically, the inverted signal V11, which is low after the pumping cycle, turns off transistor 508 to ignore the pump signal 496 and to simultaneously begin the precharge cycle (i.e. generate clock signals CP1, CP1B, CP2, CP3 and CP4 used during the precharge). As a result, the clock circuit ignores the pump signal and ensures that the pump circuit remains in the precharge cycle for a required duration to transfer adequate charge to be pumped in the subsequent pumping cycle.

During the precharge cycle, signal V11 is now input into NAND gate 530 and inverter 610. Inverter 610 turns on transistor 616 to reset the latch. As a result, both inputs to the NAND gate are now low and the output of the NAND gate is high. The operation of the clock circuit during the precharge cycle is identical to the operation of the clock during the pumping cycle, except that the output signals from the respective gates are inverted. Therefore, the clock circuit generates signals for both the pumping cycle and the precharge cycle, and remains idle after a precharge cycle if the pump signal 496 is low.

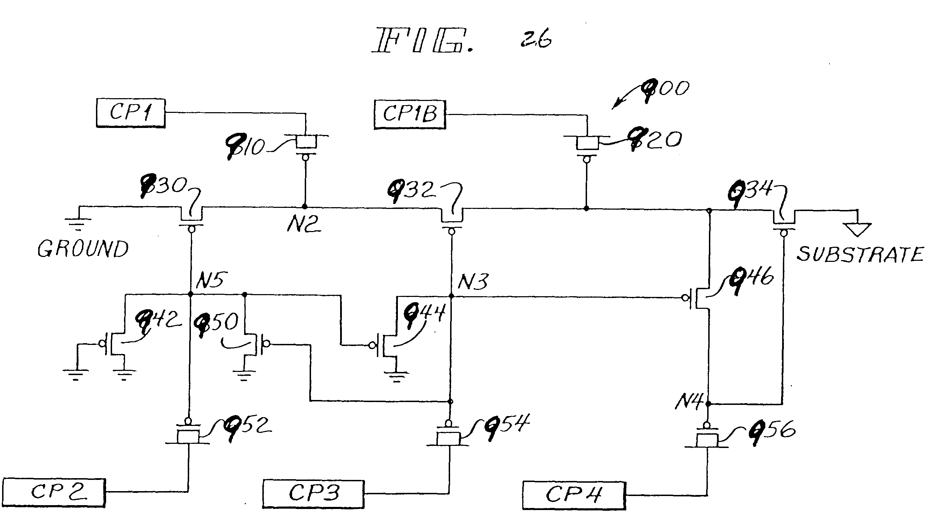

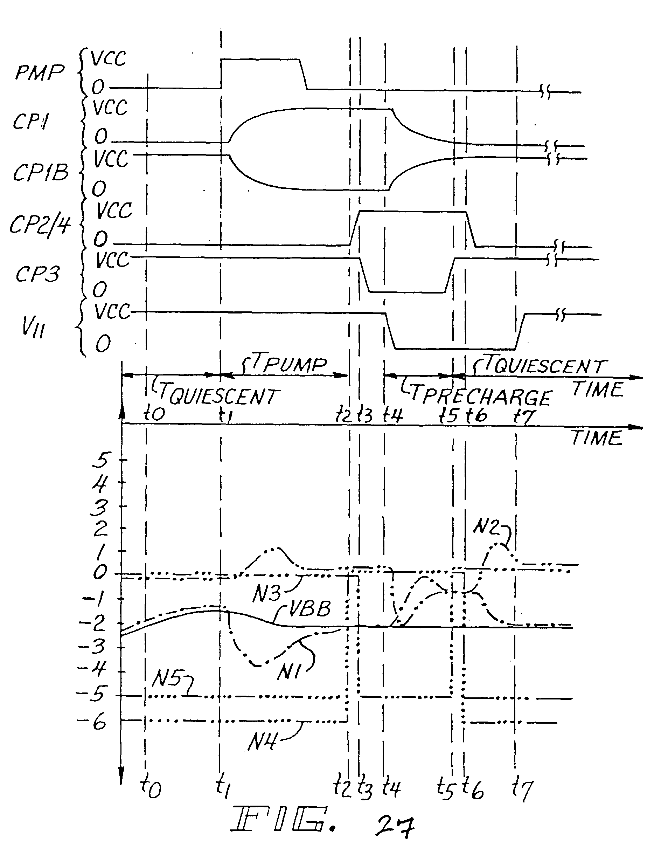

Figures 24 and 25 are more detailed schematic diagrams of the first and second stages respectively of the charge pump of Figure 23. These figures show the commonly known configuration of transistors used to form the various gates shown in block form in Figure 23. For example, an inverter shown in block form is shown as a well known configuration of two transistors. While the operation of the clock circuit 500 is best described in reference to the block diagram of Figure 23, these figures are included to show the preferred schematic diagram of the clock circuit in detail.

Figure 26 shows the pump circuit which is responsive to the clock signals generated by the clock circuit of Figure 23. The general structure of the pump circuit will be described first, followed by a more detailed description of the operation of the pump circuit during the pumping cycle and the precharge cycle. The charge circuit is a two stage charge pump having capacitors 910 and 920 coupled to receive signals CP1 and CP1B. Signals CP1 and CP1B are used to change the voltages at nodes N2 and N1 when applied to capacitors 910 and 920. Capacitors 910 and 920 allow nodes N2 and N1 to be driven to a negative potential as is required to operate the charge pump. By changing the voltages at these nodes, charge (electrons) can be transferred along the path of transistors 930, 932 and 934 from ground to the substrate, ultimately to lower the voltage V_{BB} at the substrate.

Because the charge pump of the present invention is a two-stage charge pump, charge at node N2 (stored during a previous pumping cycle) will be pumped to node N1 during the precharge cycle, before being pumped to the substrate during the pumping cycle. Signals CP2, CP3 and CP4 are used to regulate transistors 930, 932 and 934 during the pumping cycle to advance charge from GND to N2 and from N1 to V_{BB}, and during the precharge cycle to advance charge from N2 to N1. Capacitors 952, 954 and 956 are also used to drive nodes N5, N3 and N4 to a negative potential to operate the charge pump. The operation of the pump circuit will be explained in more detail in reference to Figure 27.

Figure 27 shows a timing diagram of the output signals of the clock circuit during a quiescent state (i.e. after a previous precharge cycle when the circuit is waiting for a pump signal), the pump cycle, the precharge cycle and a subsequent quiescent state. The reference to low or high clock signals is intended to mean ground potential or VCC, respectively, where VCC is preferably 3 volts or 5 volts. Voltages present during the two cycles at various nodes of the pump circuit (designated as N1-N5 in Figure 27) are also shown to provide a greater understanding of the operation of the two stage charge pump.

At a time t0 and during the quiescent period T_{QUIESCENT}, the clock signals and the voltages at the nodes are at the state after the precharge cycle is completed (which will be described later in reference to the T_{PRECHARGE} period). These clock signals and voltages will remain in that state until the clock circuit receives a signal to pump.

At a time t1, the clock circuit receives a high pump signal to begin the pumping cycle. CP1 and CP1B gradually transition to high and low voltages respectively. CP2 and CP4 are low after the previous precharge cycle, turning on transistors 930 and 934. Because CP3 is high and transistor 932 is off, there is no direct path from ground to the substrate and there can be no undesired flow of charge. As CP1 transition high, the voltage at node N2 increases and draws negative charge from GND to node N₂ via transistor 930 (which is turned on with a low CP2 signal). Therefore, node N₂ gradually equalizes to ground potential. Also, as CP1B transitions to a low level, charge (transferred from node N2 to node N1 during the previous precharge cycle) is transferred from Node N1 to the substrate, lowering V_{BB} as shown during period T_{PUMP}. As is apparent, the voltage at node N1 initially decreases, and equalizes with V_{BB} as the voltage at V_{BB} is gradually lowered to desired voltage, preferably minus two (-2) volts.

During a previous precharge cycle, node N4 is coupled to node N1 by turning on transistor 946. When transistor 946 is on, the voltage at the gate of transistor 934 is clamped to its source, ensuring that transistor 934 remains off during the precharge. Node N4 is also coupled to node N1 during the precharge cycle by turning on transistor 946 in order to maintain node N4 at a voltage below ground potential. Node N4 is maintained below ground potential at approximately minus one (-1) volt to ensure that transistor 934 will turn on as CP4 transitions to a low level and all the charge is transferred to the substrate during the pumping cycle. Finally, transistor 944 is coupled to node N3, clamping N3 to ground potential during the pumping cycle to ensure that transistor 932 remains off and no charge is transferred from node N2 (or ground) to node N1. Therefore, during the pumping cycle, charge is pumped from ground to node N2 and from N1 to the substrate.

At a later time t2, the signals CP2 and CP4 transition from low to high as signals CP1 and CP1B are passed through the second stage 700 of the clock circuit. Therefore, time t2 marks the end of the pumping stage.

At a time t3, signal CP3 transitions from high to low, preparing the circuit for the precharge cycle. Signal CP3 transitions after CP2 and CP4 transitions to provide a non-overlapping active low signal. Therefore, transistor 932 is not turned on by a low CP3 signal driving node N3 low until after transistors 930 and 934 are already turned off (i.e. when signals CP2 and CP4 previously transitioned from low to high at time t2). This timing prevents any undesirable current flow between ground and node N2 and node N1 and VBB.

At a time t4, signal V11 goes low, marking the beginning of the precharge cycle. As discussed earlier in reference to the clock circuit, the clock circuit shown in Figure 23 ignores the pump signal during the precharge cycle as the pump circuit is preparing for a subsequent pump cycle (i.e. if the clock circuit should receive a pump signal after the precharge cycle is completed). This provides the self-timed feature by ensuring that pumping circuit is fully ready to pump when it receives a pumping signal.

During the pre-charge cycle T_{PRECHARGE}, CP1 transitions to a low level and CP1B transitions to a high level. As these signals change, node N2 becomes more negative, while node N1 becomes more positive. Because CP3 is low, transistor 932 is on, allowing charge to be transferred from node N2 to node N1. However, transistors 930 and 934 are turned off with high CP2 and CP4 signals to prevent any undesired transfer of charge from ground to node N2 or from node N1 to the substrate.

The pump circuit further includes transistors 946 and 950 to ensure that transistors 930 and 934 remain off during the precharge cycle. Specifically, transistors 946 and 950 clamp the gate voltages of transistors 930 and 934 at nodes N4 and N5 to their respective source voltages to prevent any undesired transfer of charge. When CP3 is low, transistor 950 is on and clamps node N5 to ground, ensuring that transistor 930 is off during the precharge. Also, transistor 946 is on during the pre-charge cycle to ensure that transistor 934 remains off. Transistor 946 also serves another function, previously discussed in regard to the pumping cycle. Transistor 946 clamps the voltage at node N4 to node N1 (at approximately minus one (-1) volt) to ensure that the voltage at node N4 is low enough so that transistor 934 will be turned on during a subsequent pumping cycle. Therefore, no charge is transferred between ground and node N2 or node N1 and the substrate. As is apparent near the end of the T_{PRECHARGE}, the voltage at nodes N1 and N2 equalize at a resulting voltage of approximately minus one (-1) volt. As nodes N2 and N1 equalize, the charge pump is in a stable state for a subsequent pumping cycle, should the charge pump receive a pumping signal.

As signals CP1 and CP1B are transmitted through the second stage 700 of the clock circuit, CP3 transitions to a high level at a time t5, turning off transistor 932 and ending the precharge cycle. At a time t6, CP2 and CP4 transition low, turning on 930 and 934 to prepare for the next pumping cycle. The transition of the signals CP2, CP3 and CP4 is again chosen to prevent any undesired flow of current between ground and the substrate.

Finally, at time t7, signal V11 transitions to a high level, allowing the clock circuit to read the pump signal 496. If the pump signal is high, the clock circuit will generate the signals in the T_{PUMP} cycle followed by the T_{PRECHARGE} cycle. If the pump signal is low, the clock circuit remains in the quiescent state shown in T_{QUIESCENT} until receiving a high pump signal.

To recapitulate, the circuit provides a low current and low power dissipation substrate bias generator. The circuit is also draws low current by disabling the clock circuit and charge pump when in a standby mode. The circuit eliminates the need for a constantly running oscillator by providing a self-timed clock circuit. When this clock circuit receives an active pump signal, the clock circuit will generate signals to pump, followed by signals to restore the pump (i.e. during the precharge stage) to ensure adequate pumping during the subsequent pumping cycle. The self-timed feature of the clock allows the clock to ignore the pumping signal until the precharge cycle is complete.

Any type of charge pump could be used within the scope of the present invention. Specifically, a single stage charge pump or a pump employing n-channel transistors could be used. Also, the voltage bias generator of the present invention could provide an oscillatorless pump drawing low current to pump charge to a node of an integrated circuit other than the substrate to maintain that node at a desired potential.

### The Voltage-Up Converter

The preferred embodiment of the present invention includes a high-voltage regulator (or voltage-up converter "VUC") circuit 42 (Fig. 1) for low-power applications. Specifically, the circuit is designed to provide a voltage VCCP, such as when driving the access word lines in a DRAM (Dynamic Random Access Memory) or other memory devices. When the word lines of a DRAM cell are accessed, VCCP tends to drop. Therefore, it is necessary to maintain VCCP by pumping charge to a node.

The preferred VUC converter combines separate standby and active circuits for maintaining VCCP under different circumstances. Each of these circuits operates independently of the other, but may operate simultaneously, to pump charge to maintain VCCP. The standby circuit is used to respond to power up and leakage current to maintain VCCP. To minimize power consumption, the current in the standby circuit is maintained as low as possible. Specifically, the standby circuit includes a low power standby voltage regulator circuit and low power standby pump which are sufficient to respond to a decreased VCCP due to a power-up condition or leakage current. The standby regulator monitors VCCP and enables a standby clock when VCCP drops below a desired value. The standby clock generates clock signals to operate the standby pump for pumping charge to restore VCCP. The standby clock is a self-timed clock and, therefore, eliminates the need for a constantly running oscillator. Further, the standby clock and standby pump are off when VCCP is at the desired voltage in order to reduce power consumption. Only the standby voltage regulator circuit is continuously operating and drawing current.

Because it is difficult for a circuit to draw low current and still react quickly to restore VCCP to the desired potential when there is a large current draw which lowers VCCP, it is beneficial to include a separate active circuit having an active regulator, one or more active clock circuits and associated active charge pumps. The active charge pumps may be responsive to the voltage VCCP as well as a signal RASBP which indicates when a circuit or device associated with the present invention is drawing current from VCCP. Because the active regulator circuit includes components which draw more current and the active charge pump is larger and able to pump VCCP to a desired potential faster, VCCP can be maintained at the desired potential when a large amount of current is drawn by a circuit associated with the present invention, such as when the word lines are driven and more current is drawn to lower VCCP.

Additionally, multiple active pumps can be used depending upon the amount of current drawn. For example, two active pumps can be used for a 16 MEG generation DRAM having the option to refresh with 2K cycles (versus 4K cycles). Since 2K cycles refresh twice as many word lines, twice as much current is drawn to lower VCCP in this type of DRAM. Therefore, depending upon the size of pump employed, it may be beneficial to use two or more charge pumps. Although the multiple active pumps can be driven by single active clock, each active pump preferably is driven by a separate active clock.

Finally, in an alternate embodiment, the active regulator can be removed and the active pumps can be activated whenever a certain condition occurs in a circuit coupled to the voltage generator of the present invention. For example, charge pumps can be activated in a DRAM whenever RASBP signal goes low, signaling that the word lines of the DRAM are accessed. Because VCCP is often lowered when the word lines are accessed, it is possible to design the pump and related circuitry to react quickly enough to restore the charge that is lost within the time that RASBP is low.

Figure 28 is a block diagram of a voltage generator circuit 42 according to a first embodiment of the present invention.

Circuit 42 produces its output voltage VCCP at output node 46. Inputs 1014 and 1016 receive signals RASPB and 2KREFPAD, respectively. These are described infra. The voltage at output node 46 is used to drive word lines in an array of memory cells, for example, as represented by circuits 1018 and 1020 controlled by switches (e.g., decoders) S1 and S2 in Figure 28. In a typical DRAM, the voltage VCCP will be low at initial power-up, as well as through leakage current. This voltage drop at VCCP is shown by a constant current source 22 in the block diagram of Figure 28 representing the continuous current leakage. A voltage regulator circuit 1100, including standby regulator 1110 and active regulator 1200, monitors the voltage VCCP to determine whether VCCP has dropped too low. When VCCP has dropped below a desired voltage, the standby regulator activates a standby clock 1300 which outputs clock signals to drive a standby pump 1478. Because standby regulator 1110 is constantly running, it is designed to generally draw low current to minimize power consumption in the circuit. The standby circuits react quickly enough and pump enough current to maintain VCCP at a desired voltage as a result of leakage current.

However, a circuit may experience greater current loss other than merely leakage current and therefore may require an active pump. For example, when the word lines of a DRAM are driven, current is often drawn from node 46, as by operation of circuits 1018 or 1020, and this lowers the voltage VCCP. Switches S1 and S2 are closed when RASBP goes low to show the current typically drawn in a DRAM when word lines are accessed or driven. Note that the constant current sources shown in the circuit are merely representative of current loss resulting from leakage or accessing the word lines.

A low RASBP enables active regulator circuit 1200 to monitor VCCP. If VCCP is low when the word lines are accessed, then the active regulator enables the active clock 1500 to generate clock signals for active pump 1478'. Generally, the active regulator 1200 responds more quickly than the standby regulator 1110 for pumping charge to maintain VCCP when word lines are accessed. Because active regulator 1200 draws more current and consumes more power, preferably it is activated only if V_{CCP} falls or has fallen below a desired value when the word lines are accessed. In addition, active pump 1478' is a larger pump (i.e. able to pump more current than the standby pump) to pump charge to maintain VCCP more quickly when the word lines are accessed. Further, the active clock circuit is a self-timed circuit and, therefore, eliminates the need for a free running oscillator. The self-timed feature will be discussed in more detail infra.

The 2KREFPAD input 1016 is included to optionally activate a second active pump 1478'. The second active pump and associated clock circuitry is employed when a 2K refresh cycle for the DRAM is used. When a 2K refresh cycle is used, twice as many word lines are accessed, drawing more current to lower VCCP. While any number of active pumps could be used, these pumps (and related circuits) are identical. Similarly, a single active clock could drive multiple active pumps, or preferably, a separate active clock could drive each pump. Therefore, the description of active circuitry infra will refer to only one active pump and one active clock circuit.

Although both the active and standby circuits work in conjunction and may or may not operate at the same time, they will be described separately for ease of understanding.

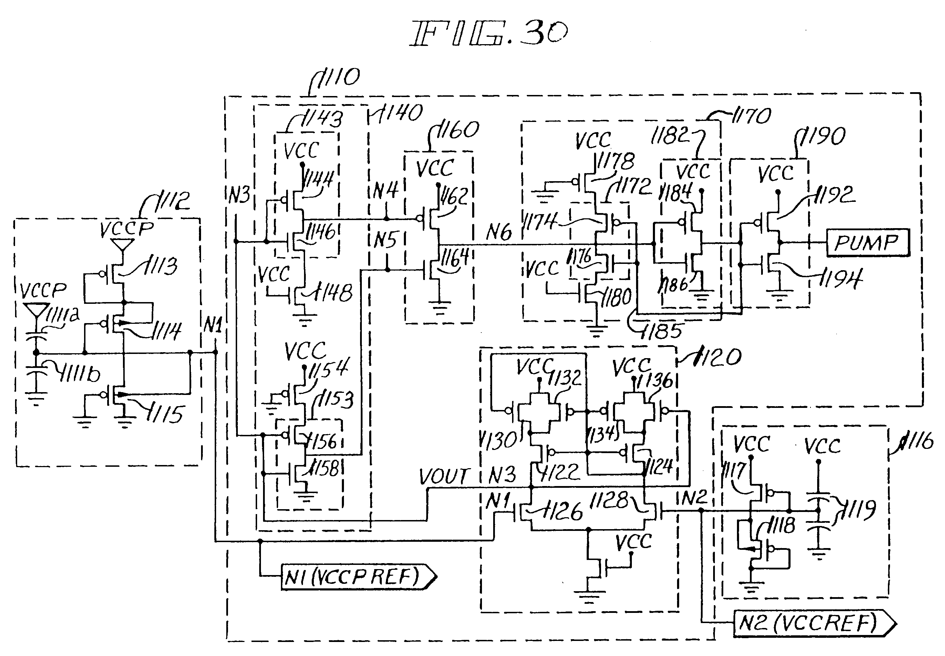

Turning now to Figure 29, a block diagram for regulator circuit 1100, which monitors VCCP for both the standby circuits and active circuits, is shown. Regulator 1100 includes a first resistor divider network 1112, having resistors 1113, 1114 and 1115 and an output node N1. Network 1112 generates a reference signal VCCP_{REF}, which is proportional to the voltage VCCP. In addition, a second resistor divider network 1116, including resistors 1117 and 1118 and an output node N2, generates a reference voltage VCC_{REF}, which is proportional to a power supply voltage VCC.

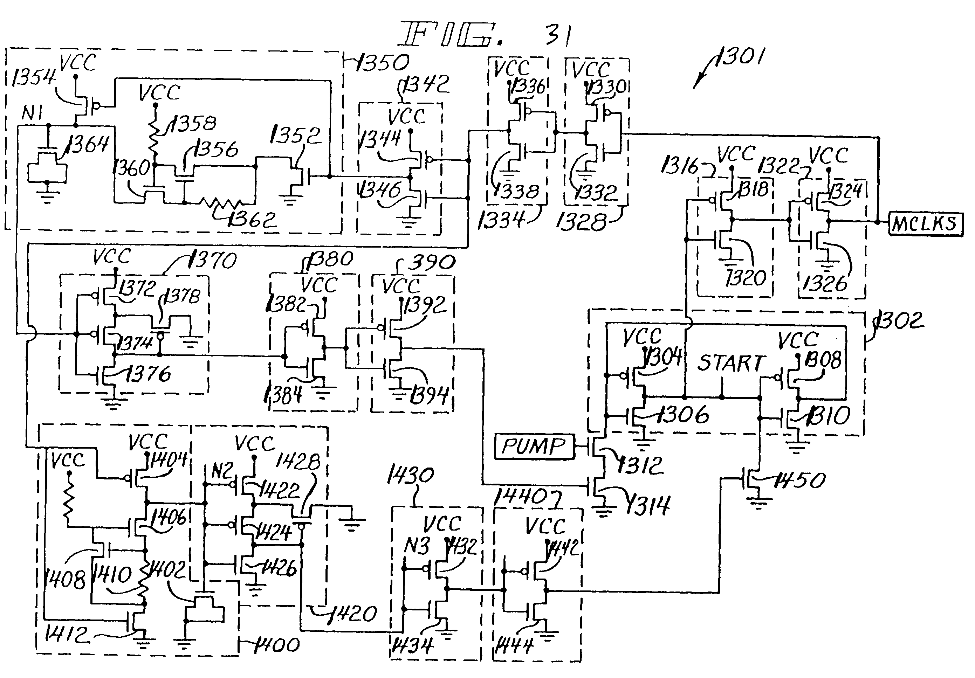

The voltage divider outputs VCC_{REF} and VCCP_{REF} are applied to positive and negative (non-inverting and inverting) inputs respectively of a differential amplifier 1120 of the standby voltage regulator 1110. When VCC_{REF} exceeds VCCP_{REF}, the output of the differential amplifier 1120 is high, outputting a high PUMP signal after being passed through a series of inverters 1140, 1150, a latch 1170 and an inverter 1190. The standby circuit is designed to limit power in the circuit, and to this end, inverters 1140, 1150, latch 1170 and inverter 1190 are included and do limit current in the circuit. The details of the inverters and latch will be described in reference to Figure 30, infra.

Active regulator circuit 1200 is also shown in Figure 29 to contrast how standby regulator circuit 1110 and active regulator circuit 1200 compare the reference voltages at nodes N1 and N2 to output signals to enable the standby and active clock circuits, respectively, which drive the standby and active pump circuits. In addition to receiving VCC_{REF} and VCCP_{REF}, active regulator circuit 1200 receives an ENREGB signal and is enabled only under certain circumstances. Active regulator circuit 1200 employs a differential amplifier 1220 which also receives reference voltages VCC_{REF} and VCCP_{REF} from resistor divider networks 1112 and 1116.

The active regulator circuit also includes an inverter 1202 and an enabling transistor 1210. Enabling transistor 1210 is responsive to the ENREGB signal and enables or disables the differential amplifier 1220 depending on whether word lines are being accessed. An enabling transistor is not used with differential amplifier 1120 of the standby circuit which outputs a signal depending only upon the voltages at nodes N1 and N2. A switch 1240 is also coupled to an inverter 1202. Switch 1240 controls whether the output of differential amplifier 1220 is passed to a Schmitt trigger inverter 1260 and an inverter 1270 to output a PUMPA signal. The active regulator circuit 1200 will be described in detail in reference to the active circuit.

Turning now to Figure 30, having shown the general operation of the voltage regulator circuit 1100 in Figure 29, additional features of the standby regulator circuit 1110 which reduce current loss and power consumption are shown in the detailed schematic diagram. The preferred devices shown in the schematic diagrams are those well known in the art (e.g. for example, transistor 1114 of Figure 30 is a P channel enhancement type transistor with the substrate coupled to the source), although other devices could be used. For example, all transistors are preferably enhancement type transistors, although depletion type transistors could be used.

In order to reduce power consumption, the standby voltage regulator circuit 1110 of Figure 30 is designed to generally operate on low current and limit current loss in the circuit. In the preferred standby regulator circuit, the resistor networks 1112 and 1116 include transistors configured as resistors (i.e., transistors having the gate tied to the source or drain). Because the current through the transistors is a function of the ratio of the channel width/length ratio, the channel lengths of these enhancement transistors are generally long to limit current through the transistor networks.

However, by choosing long transistors in the resister divider networks, the voltages at nodes N1 and N2 respectively will change slowly. Accordingly, capacitors 1111 and 1119 can be added at nodes N1 and N2 respectively to cause the voltage at the nodes to change more rapidly. Preferably, capacitor 1111a is 2pf and capacitor 1111b is 1pf. Capacitors 1119 are preferably 1pf. Although the transistors are preferably formed using metal and oxide layers on the device, transistors configured as capacitors could be used.

The differential amplifier circuit 1120 preferably consists of a conventional configuration of transistors 1122-1128 and is used to compare VCC_{REF} at a node N2 with VCCP_{REF} at a node N1 to output a PUMP signal. The dimensions of the transistors 1122-1128 of the differential amplifier circuit 1120 are chosen to keep current in the circuit low, and therefore minimize power consumption. Specifically, the width/length ratio of the transistors of the differential amplifier circuit 1120 is preferably kept small by selecting long channel lengths to limit the current flow.

Although the long channel transistors of the differential amplifier circuit limit the current flow, the circuit will generally react slowly and will output a slow changing signal at node N3 (i.e. a signal which does not have a sharp transition between low and high states). A slow changing signal can often lead to current loss in a circuit, particularly when input to a two transistor inverter. Specifically, both transistors of the inverter will be on for a certain period of time, leading to "through current" or "crowbar current" through the series of transistors. Therefore, there is often current loss from VCC to ground by way of a two transistor inverter during the transition.

To compensate for the slow changing signal at node N3, transistors 1130-1136 are added to differential amplifier circuit 1120. Generally, the sources of transistors 1130 and 1132 are coupled together at VCC, while the drains of transistors 1130 and 1132 are also coupled together to transistor 1122. The gate electrode of transistors 1130 and 1132 are coupled together and are coupled to the gates of transistors 1122, 1124 and 1134. Similarly, the sources of transistors 1134 and 1136 are coupled together at VCC, while the drains of transistor 1134 and 1136 are coupled together at transistor 1124. The gate of transistor 1136 is coupled to the output of the differential amplifier 1120.

The operation of the conventional configuration of transistors 1122-1128 of differential amplifier circuit 1120 is well known in the art. Transistors 1130-1136 are added to drive the output more quickly without drawing additional current. Particularly, these transistors drive the output V_{OUT} at node N3 of the differential amplifier circuit 1120 when output V_{OUT} is at a transition point (i.e. a point between outputting a high and low signal).

For example, as VCCP_{REF} at node N1 reaches a higher potential, transistor 1126 begins to turn on harder, pulling node N3 low. Since node N3 is coupled to the gate of transistor 1136, which is a p channel FET, it begins to turn on harder. Its source-drain path couples VCC to the source of transistor 1124, which now reaches a higher potential and, therefore, turns on transistor 1124 harder. This raises the potential at the drain of FET 1124 and the gate electrodes of transistors 1122, 1130, and 1132. This permits the output at node N3 to be pulled low even more quickly.

Conversely, circuit 1120 acts to drive the output at node N3 high quickly as VCCP_{REF} (node N1) begins to drop below VCC_{REF} (node N2). Specifically, as VCCP_{REF} begins to drop, FET 1126 becomes less conductive, permitting the voltage at node N3 to begin to rise. When this happens, p channel transistor 1136 becomes less conductive, which lowers the voltage at the source of transistor 1124. As a result, the voltage at the drain of transistor 1124 is lowered, turning on transistor 1122, 1130, and 1132 harder and driving the output at node N3 high more quickly.

While transistor 1130-1136 are added to drive the output V_{OUT} of the differential amplifier 1120 more quickly, they are also designed to limit the capacitance at output node N3. It is beneficial to limit the capacitances at node N3 because it generally takes a longer time and more charge to drive a node coupled to a large capacitive load. Specifically, because the capacitance of a transistor is directly dependent upon the channel length, a long channel length will create a large capacitive load at the node coupled to the gate of the transistor (according to the equation: C = c•l•w, where c is the capacitance of the gate oxide per unit area, l is the length of the channel and w is the width of the channel). Therefore, transistor 1136, which is coupled to node N3, is generally chosen to have a short channel length and width to limit the capacitance at the output.

To further compensate for the slow changing output V_{OUT} of the differential amplifier 1120 at node N3 (i.e., the slow changing output being a result of the differential amplifier which is designed to minimize the current in the circuit), inverters 1140 and 1160 and latch 1170 are specifically designed to reduce the "through current" in the inverters and to output a PUMP signal (i.e. clock enabling signal) having a sharp transition. The switching time of transistors is generally dependent on the channel width/length ratio. Therefore, the channel widths and lengths can be chosen to establish when the transistors of the inverters will switch. Because the widths of the transistors in inverter circuit 1140 are the same, the switching time will be a function of their channel lengths. The channel lengths of the transistors 1144, 1146, 1156 and 1158 of circuit 1140 are chosen so that the voltages at nodes N4 and N5 (and therefore transistors 1162 and 1164 of circuit 1160) switch at an appropriate time.

Specifically, when the voltage at node N3 transitions from a high signal to a low signal to change the voltage at node N6 from high to low, it is beneficial to turn off transistor 1162 before turning on transistor 1164 to limit through current from VCC to ground in inverter 1160. To accomplish the switching of the transistors of inverter 1160 in this order, the width/length ratios of the transistors of inverter 1140 are selectively chosen. Specifically, the width/length ratio of transistor 1144 is generally greater than that of transistor 1156. As a result, transistor 1144 turns on before transistor 1156 turns on. Therefore, node N4 is pulled high before node N5 is pulled high to ensure that transistor 1162 switches before transistor 1164.

In contrast, when V_{OUT} transitions from a low signal to a high signal, it is beneficial to turn off transistor 1164 before turning on transistor 1162 to limit through current from VCC to ground. Therefore, the width/length of transistors 1146 and 1158 are selectively chosen. Specifically, the width/length ratio of transistor 1158 is generally greater than that of transistor 1146. As a result, transistor 1158 turns on before transistor 1146 turns on. Therefore, node N5 is pulled low before node N4 is pulled low to ensure that transistor 1164 turns off before transistor 1162 turns on. Accordingly, the selection of channel lengths of the transistors of inverter circuit 1140 reduces any current path from VCC to ground in inverter 1160 during either transition.

To further limit through current in the voltage regulator circuit, transistors 1148 and 1154 are added to inverter 1140 to eliminate any through current in inverters 1143 and 1153. Because of the "current-limiting" transistors 1148 and 1154 have long channel lengths, nodes N4 and N5 will not be pulled rapidly to ground and VCC respectively. Therefore, a path from VCC to will exist while driving transistors 1162 and 1164, but the current will be reduced in the series of transistors 1144-1148 and 1154-1158 by the long channel lengths of transistors 1148 and 1154.

Also, transistors 1148 and 1154 are selectively positioned to ensure that the timing of the switching of the transistors as described above is not affected. When node N3 transitions from high to low, it is preferable that the inverter 1143 drive N4 high very quickly by turning on transistor 1144 to shut off transistor 1162. Therefore, "current-limiting" transistor 1148 is added only to the n-channel side of the inverter 1143 to limit the effect of transistor 1148 on transistor 1144. Specifically, because it is beneficial for transistor 1144 to switch quickly and drive node N4 high quickly, no current limiting transistor is added to the p-channel side of inverter 1143 (between transistor 1144 and VCC). While "current-limiting" transistor 1148 does effect the timing of driving node N4 low when node N3 transitions from low to high, the capacitive coupling of transistor 1148 to node N4 is large enough to pull node N4 low enough to turn on transistor 1162 at an appropriate time.

Similarly, when node N3 transitions from low to high, it is preferred that inverter 1153 drive node N5 low very quickly by turning on transistor 1158 to shut off transistor 1164. Hence, the "current-limiting" transistor 1154 is added only to the p-channel side of inverter 1153 to limit the effect of transistor 1154 on transistor 1158. A current limiting transistor is not added in series between transistor 1158 and ground in order to avoid limiting the rate at which transistor 1158 pulls N5 to ground. Although "current-limiting" transistor 1154 does affect the timing of driving node N5 high when node N3 transitions from high to low, the capacitive coupling of transistor 1154 to node N5 is large enough to pull node N5 high enough to turn on transistor 1164 at an appropriate time.

It should be understood that while the preferred embodiment employs a specific differential amplifier circuit 1120 shown in Figure 30, other circuits which compare two signals to provide an output could be used within the scope of the present invention.

Finally, the standby regulator circuit 1110 includes a latch 1170 to maintain the output of the PUMP signal during the period when neither transistor 1162 nor transistor 1164 of inverter 1160 is on (as discussed above to prevent through current). The inverted PUMP signal is fed back via line 1185 to transistor network 1174-1180 to maintain the original voltage at node N6 until the state of N6 changes when inverter 1160 drives node N6.

In order to reduce the power consumption of the oscillator, latch 1170 itself is designed to limit the through current while also providing a weak latch. Transistors 1162 and 1164 are generally small transistors (i.e., small widths and lengths) to limit the current required from inverter 1140 to switch inverter 1160. However, because of their size, they generally cannot drive a large capacitive load at node N6. Too large a capacitance at node N6 is undesirable because this capacitance will cause the voltage at the node to switch slowly. Therefore, a weak latch is provided at node N6 by selecting transistors 1174 and 1176 to have smaller widths and lengths, preferably on the order of 1-2 µm, to limit the capacitance.

However, because transistors 1174 and 1176 of the latch have widths and lengths which are about equal, they also have a large width/length ratio and drive greater current. Therefore, "current-limiting" transistors 1178 and 1180 are included. These transistors have long channel lengths (and therefore small width/length ratios) to limit the current in the latch 1170 and reduce power consumption in the circuit.

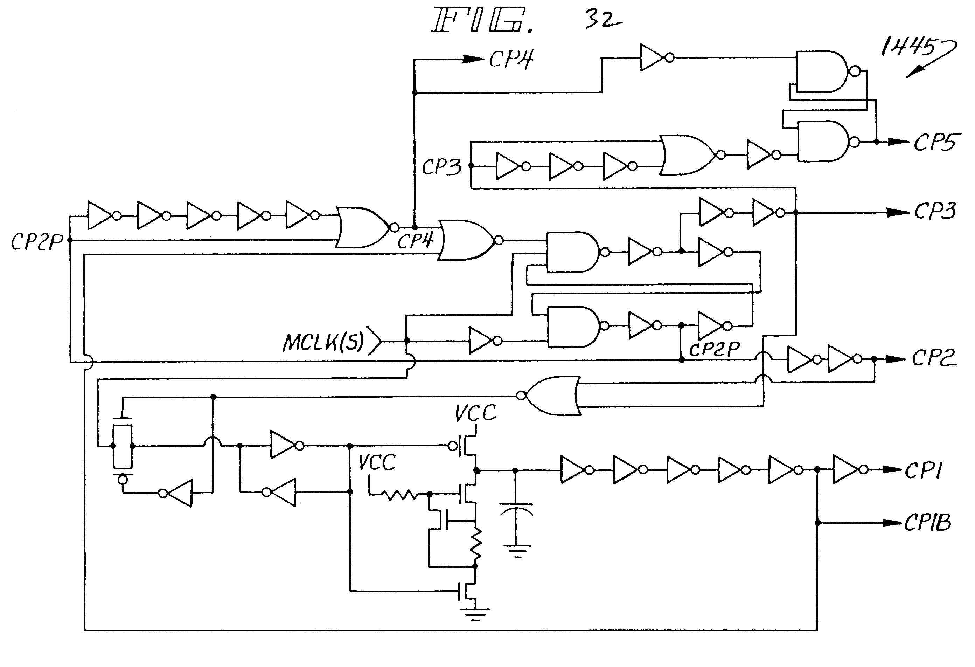

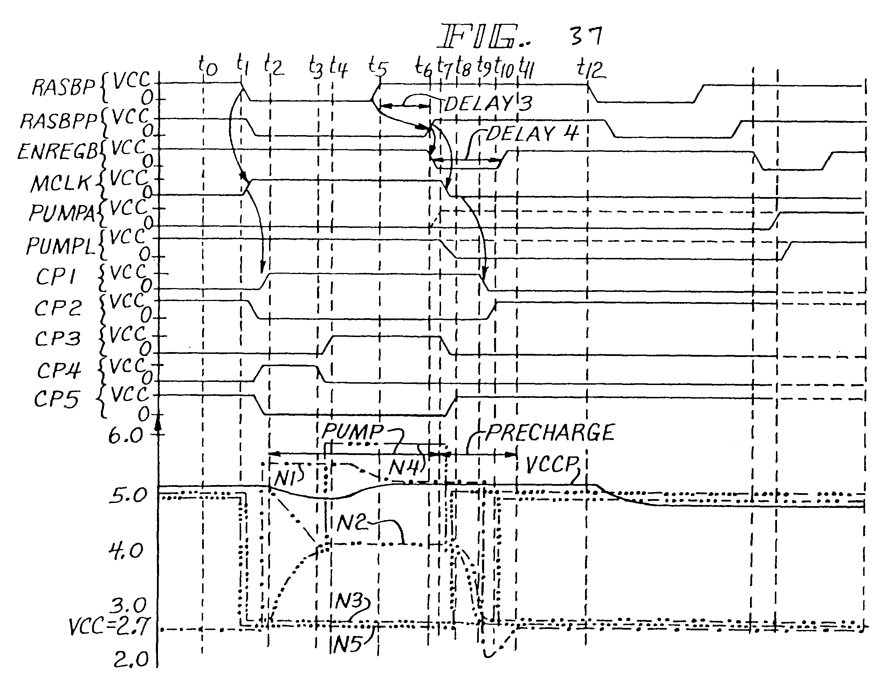

Turning now to Figure 31, having shown the detailed schematic of the standby regulator circuit 1110, the description of the remaining circuitry of the standby circuit (i.e. the standby clock circuits and the standby pump circuit) will be in described in reference to the various cycles of the pump. The master clock circuit 1301 for the standby clock 1300 is shown in Figure 31. Circuit 1301 receives the PUMP signal at an input and produces a master clock output signal MCLKS. As will become apparent in reference to the pump circuit (shown in Figure 36), the pump circuit pumps on a two-cycle principle: a precharge cycle and a pumping cycle. Therefore, the clock circuit must generate different signals during these cycles. The clock signals generated during the pumping cycle will be described first, followed by the clock signals generated during the precharge cycle.

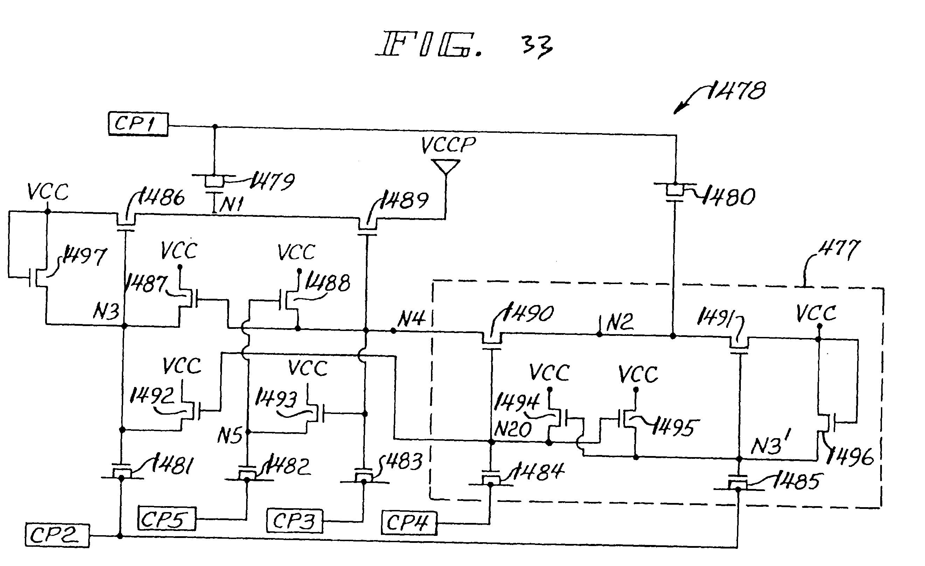

The operation of the standby master clock circuit 1301 of Figure 31 which generates the master clock signal MCLKS for the standby circuit will be described first, followed by the operation of a clock circuit 1445 shown in Figure 32. As described in reference to the block diagram of Figure 29, when the constantly running standby regulator 1110 (Figure 30) detects that VCCP_{REF} has fallen below a selected value, the standby regulator will output a high PUMP signal. At the beginning of the precharge pump cycle, a high PUMP signal drives the gate of transistor 1312 high. Initially, as described infra, FET 1314 is on, so that when FET 1312 turns on, it pulls the gates of transistors 1304 and 1306 low. Transistors 1304 and 1306 form an inverter having an output node "START," which thus is pulled high. The output MCLKS of master clock circuit 1301 is high after START is transmitted through a sequence of inverters 1316 and 1322. Although preferably a high pump signal and MCLKS signal are generated by the circuits to drive the charge pump, the circuits could be configured to generate active low pump and MCLKS signals within the scope of the present invention.

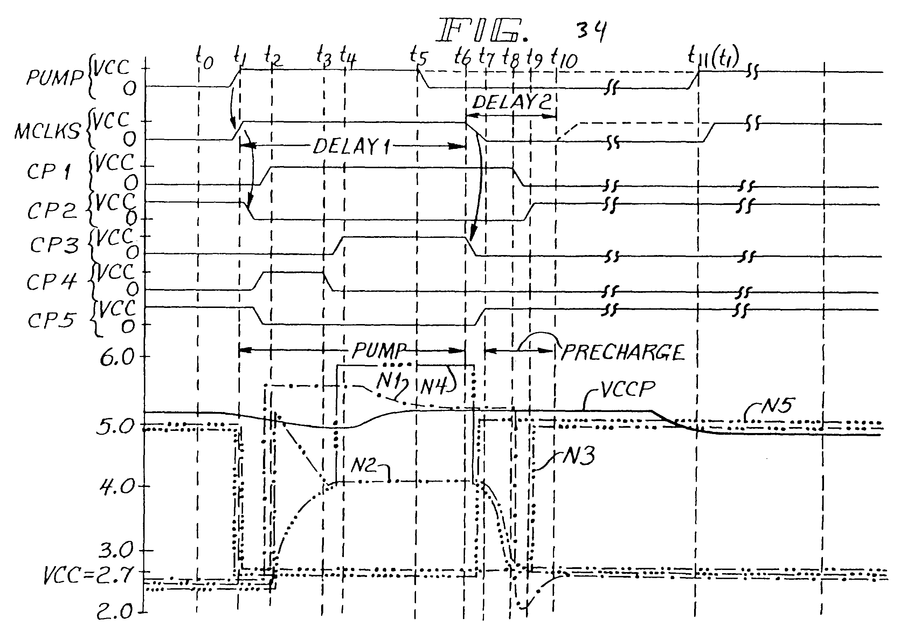

Because the MCLKS signal is used to enable a clock circuit 1445 (shown in Figure 32) which generates clock signals to drive the standby pump (shown in Figure 33) during different cycles, MCLKS varies during the different cycles. Therefore, the feedback operation of standby master clock circuit 1301 designed to change the MCLKS signal (i.e., between a binary low and binary high signal) will be described first, followed by a description of the clock circuit 1445 which receives the MCLKS signal.

While the pumping cycle is completed when MCLKS is high, MCLKS is fed back through circuit 1301 of Figure 31 to generate a low MCLKS during the precharge cycle to reset the inputs and voltages at the nodes of the pump circuit for the next pumping cycle. After passing through inverters 1328 and 1334, MCLKS signal follows two paths. Two paths are designed to establish the proper voltages at node START for the precharge and pumping cycles. Depending on the state of MCLKS, MCLKS signal generally will be transmitted through the circuit quickly in one of the paths, while a delay will be provided in the other path. Generally, a first path exists through an inverter 1342, a delay circuit 1350, and gates 1370, 1380 and 1390. A second path is provided by a delay circuit 1400 (having inputs at the gate electrodes of transistors 1404 and 1412) and inverter 1430 and 1440. Because the signal from the fast path (i.e. either the first or second path, depending upon the state of MCLKS) reaches a latch 1302 first and, therefore, establishes a condition of the latch, the fast path will be discussed first, followed by the slow path.

When MCLKS is high (for example, during the pumping cycle), the signal is passed through inverters 1328 and 1334 and a high signal is input to inverter 1342. The output of inverter 1342 is low, turning on a transistor 1354 and turning off a transistor 1352. Because there is no path from a node N1 to ground through transistors 1352 and 1360, capacitor 1364 is pulled to VCC via the source-drain path of FET 354. As a result, capacitor 1364 charges quickly, providing the fast path through the circuit to latch 1302. Specifically, the voltage at node N1 is transmitted through Schmitt Trigger inverter 1370 and inverters 1380 and 1390 to output a low signal at the gate of a transistor 1314, turning it off. With transistor 1314 off, the circuit ignores the PUMP signal at the gate of transistor 1312, providing the self-timed feature of the circuit. Accordingly, an oscillator is not needed to provide timing for the clock circuit.

At the same time, the output of inverter 1334 is input to delay circuit 1400 (which provides the slow path of the circuit in this case). Because the output of inverter 1334 is high, transistor 1404 is off and transistor 1412 is on. Therefore, a path from a capacitor 1402 through transistor 1406 and resistor 1410 is provided to ground, leading to the discharge of capacitor 1402. Because capacitor 1402 is relatively large, preferably 1.2 pf, and resistor 1410 is also large, preferably 10KΩ, this discharge of the capacitor provides a long delay (preferably 40-60 nanoseconds). The delay provided by discharging the capacitor is established to ensure the pump circuit 1478 completes the pumping cycle (described in detail in reference to the pump circuit).
The voltage at node N2 of the capacitor 1402 is input to a Schmitt Trigger inverter 1420 and inverters 1430 and 1440 to provide an output to the gate of a transistor 1450. The high output at the gate of the n-channel transistor 1450 turns it on, thereby pulling the node START to ground and inverting the latch 1302. The low voltage at the node START is transferred through inverters 1316 and 1322 to provide a low MCLKS output signal which starts the precharge cycle of the pumping circuit to prepare the circuit for the next pumping cycle.

When master clock MCLKS is low, MCLKS is passed through inverters 1328 and 1334, providing a low output of inverter 1334. The output of inverter 1342 is high, turning off transistor 1354 and turning on transistor 1352. Because a path from capacitor 1364 to ground is provided by way of transistors 1360 and 1352, allowing for the discharge of capacitor 1364 (i.e., node N1), the delay through delay circuit 1350 is long, while the delay through delay circuit 1400 is short. Therefore, the passage of the low MCLKS through delay circuit 1350 will be described after the short path through delay circuit 1400.

The low output signal of inverter 1334 is input to transistors 1404 and 1412 of delay circuit 1400. The low signal turns on transistor 1404 and turns off transistor 1412. Therefore, the capacitor 1402 is coupled to VCC via transistor 1404 and the capacitor charges quickly, pulling the voltage at node N2 high. The voltage at node N2 is transmitted through Schmitt trigger inverter 1420 and inverters 1430 and 1440. A low output of inverter 1440 is input to transistor 1450. The low signal at the gate of transistor 1450 turns off the transistor and allows the pumping cycle to begin again after the signal passes through the slow path (i.e., delay circuit 1350) and the circuit receives an active pump signal to reset latch 1302.

When the low MCLKS passes through delay circuit 1350 (i.e., during the precharge cycle), the discharge of capacitor 1364 generally provides a delay.

Specifically, the low output of inverter 1334 is input to inverter 1342. The output of inventer 1342 is input to delay circuit 1350. The high input turns on transistor 1352 and turns off transistor 1354. As a result, a path is provided from capacitor 1364 to ground by way of transistor 1360, a resistor 1362 (preferably 10KΩ) and transistor 1352. A transistor 1356 and resistor 1358 (preferably 10KΩ) are added to maintain a constant current in the path from node N1 to ground and, therefore, establish a set delay. During this delay, the inputs to the pump circuit and voltages at various nodes of the pump are reset for a subsequent precharge and pumping cycle.

As the voltage at node N3 goes low as capacitor 1364 discharges, the voltage is transmitted through Schmitt trigger 1370, inverter 1380 and inverter 1390 to provide a high output at the gate of transistor 1314. A high signal at the gate of the n-channel transistor 1314 turns on the transistor and allows transistor 1312 to receive the pump signal for the subsequent pumping cycle.

This delay for the precharge cycle (set by delay circuit 1350) is generally shorter than the delay for the pumping cycle (set by delay circuit 1400) by providing a smaller capacitor which is discharged. A long delay during the precharge cycle is not required because the internal voltages in the pump reach precharge levels more quickly. This is because the gate-to-source voltages are higher and can react or provide more current at a faster rate.

To recapitulate, the standby master clock circuit 1301 shown in Figure 31 is responsive to an active PUMP signal (or clock enabling signal from the standby regulator circuit shown in Figure 30 when VCCP_{REF} drops below a certain value) and generates the MCLKS signal. MCLKS is fed back through the circuit and varies during different cycles. MCLKS is input to the clock circuit 1445 shown in Figure 32. As MCLKS transitions high or low, clock circuit 1445 generates different clock signals during the different cycles to drive the charge pump.

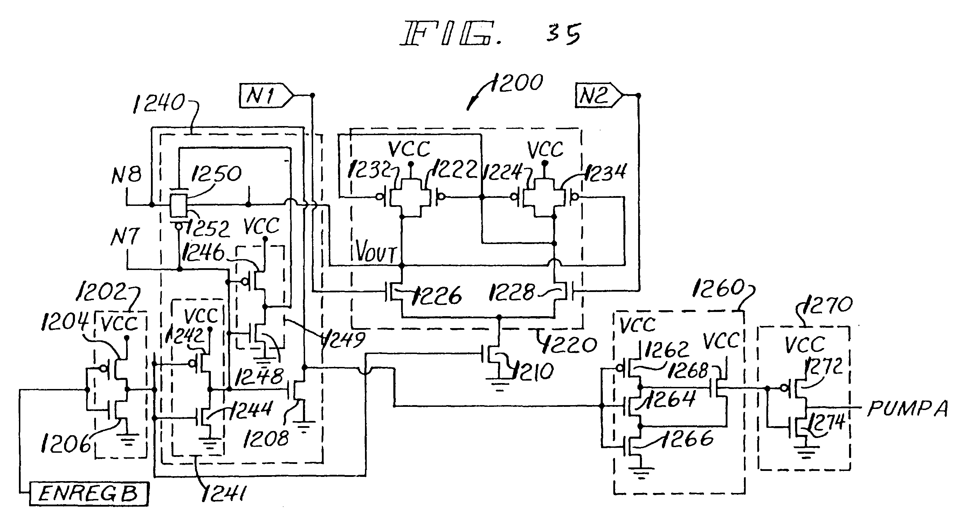

Turning now to Figure 32, clock circuit 1445 is shown. Clock circuit 1445 receives MCLKS at an input and outputs signals CP1 through CP5. This circuit shows the preferred configuration of gates to generate the signals to drive the charge pump in Figure 33. The signals generated by clock circuit 1445 are shown in the timing diagram of Figure 34. Clock circuit 1445 uses a series of gates and feedback paths to generate the outputs shown in the timing diagram of Figure 34. The operation of each gate shown in Figure 32 is well known in the art. Generally, each signal is a part of a feedback loop to provide an inverted output depending on the status of the signals. As a result, the outputs transition based upon state of the master clock signal as well as the previous signal.

The configuration of the gates is designed to establish the signals shown in Figure 32. One skilled in the art could follow the MCLKS input signal to generate the output signals in Figure 32 at any period based upon the previous input signals. While the preferred clock circuit is shown in Figure 32, any other circuit or other means of generating signals (CP1-CP4) shown in Figure 32 could be used to generate the input signals to the pump circuits.

The function of the clock signals generated by the circuit of Figure 32 will be described in detail in reference to the operation of the charge pump of Figure 33. The clock signals are shown as a function of time in Figure 34. The structure of the charge pump circuit will be described in detail, followed by a detailed description of the operation of the charge pump.

Turning now to Figure 33, the charge pump circuit 1478 is shown. Pump 1478 receives at several inputs the clock signals CP1 through CP5, and provides an output VCCP. While the operation of the pump is shown having a 2.7 volt VCC, some other value of VCC could be used. The use of a 2.7 volt VCC is simply illustrative.

The charge pump of the present invention is a hybrid two-stage charge pump having a first stage 1477. Charge pumped to a node N4 during the first stage of a pump cycle (by first stage 1477) is used to enable the charge pump to pump charge from a node N1 to VCCP during a second stage of the pumping cycle. Generally, signal CP1 is used to drive nodes N1 and N2 to a greater potential by way of capacitors 1479 and 1480. Signals CP2, CP3, CP4 and CP5 are generally used to regulate the operation of the remaining transistors in the circuit to pump charge to VCCP during the pumping cycle, and to reset the nodes during the precharge cycle.

Referring to the pump circuit of Figure 33 and the associated timing diagram of Figure 34, the operation of the pump circuit will be described. The input signal to the pump circuit and the voltages at various nodes are shown at t0 when the pump circuit is in a quiescent state. As stated earlier, the input signals CP1 to CP5 are established by the clock circuit 1445 shown in Figure 32, while the voltage at the nodes of the pump circuit in Figure 33 are determined by the clock signals CP1-CP5. Initially, CP2 is high (VCC), turning on transistors 1486 and 1491 to maintain nodes N1 and N2 at VCC.

At a time t1, PUMP signal goes high (after the standby voltage regular circuit 1110 shown in Figure 30 detects a drop in VCCP). As described in reference to the standby master clock circuit 1301 of Figure 31, MCLKS signal also goes high. As MCLKS is passed through the clock circuit 1445 shown in Figure 32, CP2 goes low (0 volts), turning off transistors 1486 and 1491 to prevent any transfer of charge from node N1 by way of transistor 1486 to VCC and to prevent any transfer of charge from node N2 by way of transistor 1491 to VCC. CP4 also goes high to turn on transistor 1490 and to allow transfer of charge from N2 to N4 (when CP1 goes high at t2). Also, CP5 goes low to turn off transistor 1488 and unclamp node N4 from VCC. At a time t2, CP1 goes high, driving the voltage at nodes N1 and N2 to approximately 2VCC (or 5.4 volts for a 2.7 volt VCC). Because transistor 1490 is on, node N4 approaches 2VCC (or approximately 2VCC minus Vₜ or 3VCC/2). This transfer of charge is necessary to turn on transistor 489 at a time t4. At a time t3, CP4 goes low to turn off transistor 1490 and to end the first stage of the pumping cycle of node N4 by preventing a transfer of charge from node N4 to node N2. At time t4, CP3 goes high to start the second stage of the pumping cycle. A high CP3 signal turns on transistor 1489 to allow the transfer of charge from node N1 to VCCP. As is apparent in Figure 34, the charge at node N1 and VCCP begin to equalize. At a time t5, the pump signal may or may not go low (as shown by the dotted line), depending on whether VCCP has been restored to its desired value. The dashed line designating a high pump signal is shown in Figure 34 and will be discussed further in regard to the end of the precharge cycle (at time t10). At a time t6 (regardless of whether VCCP is restored to its desired value), the pumping cycle is complete as the high MCLKS signal is fed back through the master clock circuit 1301 (discussed in Figure 31). As MCLKS goes low, CP3 goes low to end the pump cycle. The pump must then reset the inputs (CP1-CP5) and the voltages at the nodes (N1-N5) to their quiescent values for the next precharge and pumping cycle. At a time t7, CP5 transitions high to couple node N4 to VCC. At a time t8, CP1 transitions low to drive nodes N1 and N2 to VCC. At a time t9, CP2 goes high to couple nodes N1 and N2 to VCC and maintain the voltage at the node. At a time t10, MCLKS has passed through master clock circuit 1301 to turn on transistor 1314 to receive a pump signal. If enough charge had not been pumped as of t5 (i.e., the PUMP signal had not gone low as indicated by the dashed line), pumping would begin at time t10 as MCLKS goes high (as shown in the dashed line). The precharge cycle would again begin as shown at time t1. Otherwise, the circuit remains in a quiescent state until a time t11, when VCCP has again dropped and an active PUMP signal is generated by the standby regulator 1110 to begin the pumping cycle again.

To recapitulate, the standby circuit used herein monitors VCCP and activates the standby charge pump to maintain a desired voltage at VCCP. Generally, the standby regulator circuit, clock circuit and standby pump are designed to consume low power. Specifically, only the standby regulator circuit is constantly operating to monitor VCCP and is specifically designed to minimize power consumption. The clock circuit and pump circuits are enabled and draw current only when VCCP has dropped below a desired value, due typically to leakage current or initial power up.

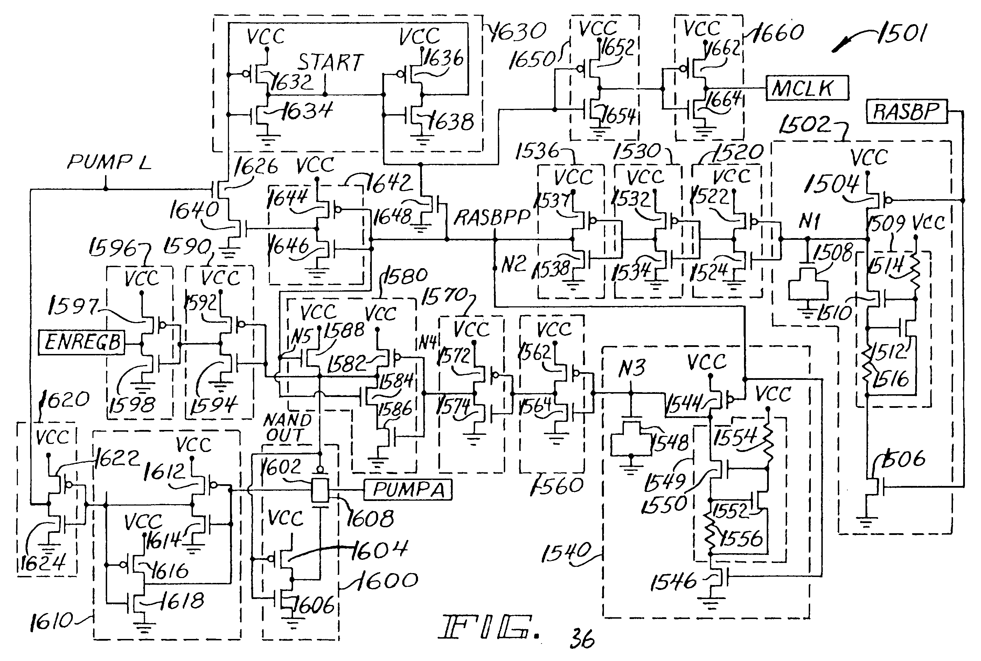

Having shown the standby circuit which continuously monitors VCCP to determine if VCCP has fallen due to leakage current, the active circuits (1500) will now be described. Generally, active clock circuit 1500 includes active regulator 1200 (Figure 35), active master clock 1501 (Figure 36), clock circuit 1445 (Figure 32) and pump circuit 1478' (Figure 33). As mentioned earlier, the active circuits operate independently of (although simultaneously with) the standby circuits and are enabled when the word lines of a DRAM are accessed, as indicated by a RASBP signal. If VCCP drops below a desired value when the word lines are accessed and the active circuit is enabled, the active pump (which is generally a larger pump than the standby pump) will pump charge to VCCP to maintain the desired voltage at VCCP.

Turning to Figure 35, active regulator circuit 1200 (also shown in block form in Figures 28 and 29) also regulates the voltages VCCP_{REF} and VCC_{REF} at nodes N1 and N2, respectively, to determine if VCCP has fallen below a desired value. Unlike the standby regulator 1110 which activates standby clock 1300 whenever VCCP drops below a desired value, the active regulator 1200 also receives an ENREGB signal, which enables or disables the active regulator circuit 1200. The state of ENREGB signal is determined, for example, by whether the word lines of a DRAM are driven and, therefore, the circuit is drawing current which lowers VCCP.

Specifically, a low ENREGB signal is inverted by inverter 1202 and drives the gate of transistor 1210 to enable differential amplifier 1220. Differential amplifier 1220 includes the conventional configuration of transistors 1222-1228. The operation of the differential amplifier is well known in the art. However, the differential amplifier further includes transistors 1232 and 1234 to enable the amplifier to respond more quickly to provide an output at V_{OUT}. Transistors 1232 and 1234 generally serve the same functions as transistors 1130 to 1136 of standby differential amplifier 1120 (Fig. 30). However, because long channel transistors are not used in this differential amplifier (unlike those of the standby differential amplifier 1120) to limit current, the capacitance at the output node V_{OUT} is not as great. Therefore, transistors 1232 and 1234 could be coupled in parallel to transistors 1222 and 1224, respectively, to more quickly drive the output without increasing the capacitance at the output node V_{OUT.}

A switch 1240 is also responsive to the ENREGB signal to allow the output of the differential amplifier 1220 to be output as a PUMPA signal (similar to the PUMP signal of the standby master clock circuit). Specifically, a low ENREGB signal is twice inverted by inverters 1202 and 1241, so node N7 is also low and is coupled to the gate of transistor 1208, turning off the transistor. The low output of inverter 1241 is inputted to inverter 1249 and is also applied to the gate of transistor 1252, which turns on. The output of inverter 1249 turns on transistor 1250, providing a path from the output of the differential amplifier (V_{OUT}) to the output at PUMPA by way of inverters 1260 and 1270. Specifically, the output V_{OUT} of differential amplifier 1220 is transmitted through the switch 1240 to node N8. Node N8 is coupled to a Schmitt trigger inverter 1260, the output of which is inverted by an inverter 1270 to provide the output signal PUMPA. The PUMPA signal is used by the active master clock circuit 1501 (shown in Figure 36) to generate a MCLK signal.

Turning now to Figure 36, the active master clock circuit 1500 outputs a high MCLK signal when an input RASBP is low and an input PUMPL (i.e. PUMPA previously latched as PUMPL) is high. Generally, a high RASBP drives ENREGB low which enables the active voltage regulator described supra in Figure 35 to monitor VCCP. If V_{CCP} has dropped below a desired value, the active voltage regulator will output an active PUMPA signal (which is input to the active master clock circuit 1501 of Figure 36). When PUMPL is high, MCLK is high to enable a clock circuit to drive the pump circuit. Note that the same clock circuit 1445 shown in Figure 32 is used to generate clock signals CP1-CP5 to drive the active pump circuit 1478'. Also, the active pump circuit 1478' is identical in structure to the standby pump circuit. However, transistors having different channel widths and lengths are used in the active pump circuit to drive more current to maintain the voltage at VCCP.

In addition, the operation of clock circuit 1445 and the active pump circuit 1478' is identical to that of the standby circuit. Specifically, clock circuit 1445 is responsive to the MCLK signal (similar to MCLKS of the standby master clock circuit 1301) to generate clock signals to operate the active pump circuit 1478'. The relationship of the MCLK signal to the clock circuit 1445 and the active pump circuit 1478' has been described in detail in reference to the standby circuit and will not be repeated here. Therefore, only the role of the RASBP signal (indicating that the word lines of a DRAM are being accessed) and other signals in the active master clock circuit 1501 to generate a MCLK signal will be discussed in detail.

The detailed operation of active master clock circuit 1501 of Figure 36 is now described. Because RASBP can be either high or low (indicating whether the word lines of a DRAM are being accessed and the active pump should be activated if VCCP drops below a given value), the operation of the circuit will be described separately in both states. When RASBP transitions from high to low (i.e. the word lines will be driven), delay circuit 1502 provides a low RASBPP at node N2 after a small delay. RASBPP is a signal which remains low for an additional period of time longer than RASBP, as will be explained infra. When RASBP goes low, a transistor 1506 is turned off, decoupling the path from a current source 1509 to ground. A low RASBP signal also turns on a transistor 1504, which couples a node N1 to VCC. Because FET 1504 presents little resistance between node N1 and VCC, capacitor 1508 charges almost immediately and node N1 transitions quickly to VCC. This high state at node N1 provides a low RASBPP after passing through a sequence of inverters 1520, 1530 and 1536.

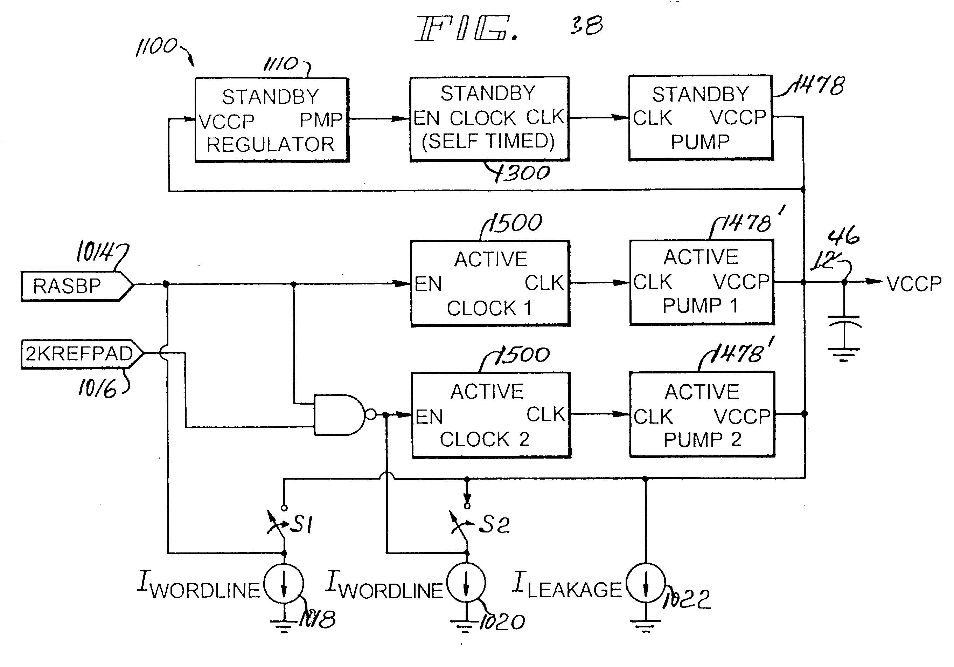

RASBPP signal is input to a number of circuits which control the output MCLK. Generally, the timing of the circuit will be understood in reference to the diagram of Figure 37. Typically, a constant current source is used to discharge a capacitor to set a delay, although other means of setting the delay could be used. Note generally in Figure 37 that when RASBP transitions low (i.e. at a time t1) RASBPP transitions low after only a very short delay. However, when RASBP transitions from low to high at a time t5 (discussed in detail infra), RASBPP does not transition high until time t6 after a delay 3 (shown in Figure 37). This delay is used to ensure that the pumping cycle lasts sufficiently long enough to pump charge and maintain the desired voltage VCCP.

In the preferred embodiment, when the RASBPP signal transitions from high to low, transistor 1546 of the delay circuit 1540 is turned off, decoupling the path from current source 1549 to ground. Also, transistor 1544 is turned on, coupling the capacitor 1548 at node N3 to VCC. This capacitor charges quickly, providing a high output at node N3 to inverters 1560 and 1570.

The output of inverter 1570 and signal RASBPP are input to a NAND gate 1580 at nodes N4 and N5 respectively. The output of the NAND gate (NAND OUT) is therefore high. This high output of the NAND gate provides a high ENREGB signal after NAND OUT passes through inverters 1590 and 1596. Therefore, when RASBP is low, active master clock circuit 1500 disables the active voltage regulator circuit 1200 (shown in Figure 35) and regulator 1200 then no longer monitors VCCP or transmits a high PUMPA signal if VCCP has dropped below a desired value.

The output (NAND OUT) of NAND gate 1580 also coupled to a switch 1600. This switch generally allows the PUMPA input signal to be latched by latch 1610 (as PUMPL). Inverters 1590 and 1596 are coupled to the output of NAND gate 1580 to add a short delay to ensure that switch 1600 is disabled before ENREGB goes high to disable the voltage regulator circuit. This ensures that the correct PUMPA signal is latched.

Latch circuit 1610 is coupled to an inverter 1620, the output of which is a signal PUMPL. When RASBPP is low, switch 1600 prevents the PUMPA signal from being transferred to transistor 1626. Therefore the value of PUMPL will be determined by the previously latched PUMPA signal (i.e. when RASBPP was previously high). PUMPL is input to a transistor 1626. The latch 1630 will be allowed to receive PUMPL when transistor 1640 is turned on by a low RASBPP signal passed through inverter 1642. When RASBPP is low, transistor 1648 is turned off and the output of latch 1630 is determined by PUMPL.

The output of latch 1630 is passed through inverters 1650 and 1660 to generate the output signal MCLK. If PUMPL is high and RASBPP low, the START signal will be high, which is output through inverters 1650 and 1660 to provide a high MCLK. If PUMPL is low, the START signal will be low to provide a low MCLK.

Next, the operation of active master clock 1501 will be described as RASBP transitions from low to high at time t5. When this occurs, transistor 1504 is turned off and transistor 1506 is turned on. Therefore, capacitor 1508 discharges to ground through constant current source 1509. Therefore, a delay is provided (designated as delay 3 in Figure 37). As stated earlier, this delay is to ensure that the pumping circuit 1478' remains in the pumping cycle for a sufficient time to adequately pump VCCP to a desired voltage. As capacitor 1508 discharges, the low signal at node N1 is transmitted through inverters 1520, 1530 and 1536. The output of inverter 1536 provides a high RASBPP signal at a time t6 after capacitor 1508 is discharged (i.e. after delay 3).

The high RASBPP signal is input to delay circuit 1540. The high signal turns off transistor 1544 and turns on transistor 1546, providing a path from capacitor 1548 at node N3 to ground by way of current source 1549. As the capacitor 1548 discharges at node N3 a delay is provided. During this delay, RASBPP is high while the output of inverter 1570 is high. Both RASBPP and the output of inverter 1570 are input to NAND 1580. As a result, the output (NAND OUT) of the NAND gate is low, opening switch 1600 and providing a low ENREGB.

After transistor 1548 discharges, the output of inverter 1570 is low, driving the output of the NAND gate (and ENREGB) high.

This delay (designated as delay 4 in Figure 37) is provided to ensure that ENREGB remains low for a predetermined time for the voltage regulator circuit to compare VCCP_{REF} with VCC_{REF} to determine whether to pump on the next cycle where RASBP goes low. Also, as stated earlier, inverters 1590 and 1596 are added to the output of the NAND gate 1580 to ensure that ENREGB stays low when switch 1600 is closed (i.e. when the output NAND OUT of the NAND gate 1580 goes low) to ensure that the correct PUMPA signal is latched by latch 1610 when RASBP is high.
At the same time that the high RASBPP signal generates the ENREGB signal to determine whether to pump when RASBP goes low, the high RASBPP also generates a low MCLK signal (at time t7 in Figure 37). Specifically, the latch 1630 will be allowed to receive PUMPL only when transistor 1640 is turned on by a low RASBPP signal passed through inverter 1642. Because RASBPP is high, the output of inverter 1642 is low, turning off transistor 1640 to ignore the PUMPL signal, providing a self-timing clock which eliminates the requirement for an oscillator. Also, the gate of transistor 1648 is high, turning on the transistor to drive the START node low and to generate a low MCLKS signal.

When RASBPP goes low at a later time, switch 1600 is closed, and the circuit is ready to pump based upon the previously determined pumping signal (PUMPL) which is input to the gate of transistor 1626 to output an appropriate MCLK signal. Therefore, MCLK will drive the active charge pump only when the appropriate conditions exist (i.e. when the RASBP signal indicates that the word lines are activated, drawing charge from VCCP, and when PUMPA (latched as PUMPL) has gone high indicating that VCCP has dropped.)

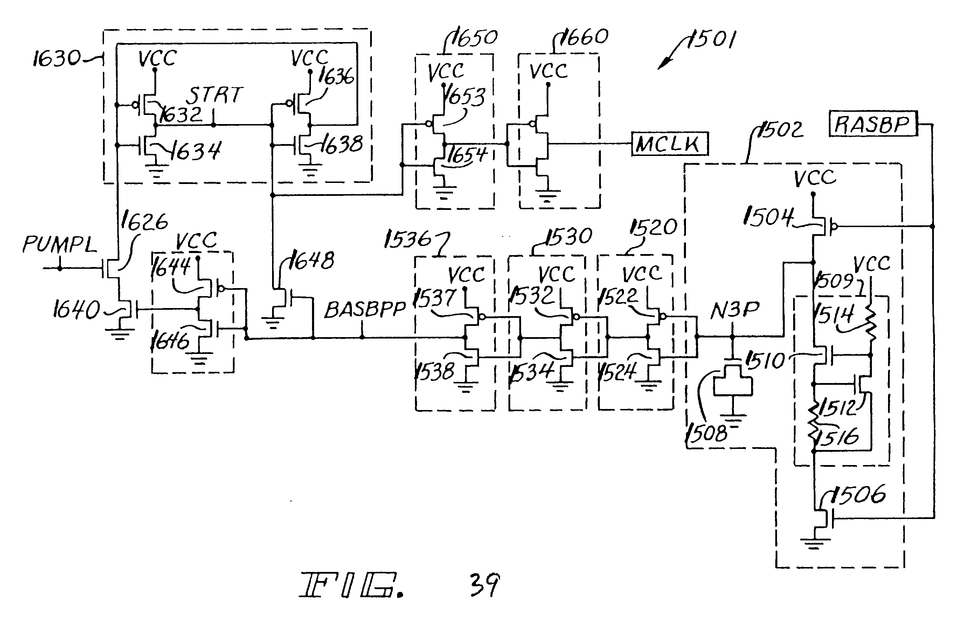

In a second embodiment, the active regulator circuit can be eliminated as shown in the block diagram of Figure 38 and the charge pump can pump whenever RASBP goes low. The only difference in this embodiment compared to the first embodiment can be found in the master clock circuit 1501. Like circuit components in Figure 39 are numbered the same as those in Figure 36. The primary difference in the circuit is that the circuit does not require an active regulator. Rather, a pump signal (i.e. PUMPA or PUMPL) is pinned at VCC and the output MCLK of this master clock circuit is high whenever RASBP goes low. The operation of this circuit is identical to the circuit in Figure 36, excluding any requirement to generate a PUMPA signal, a PUMPL signal and an ENREGB signal, and therefore, is not described again in detail here.

## Claims

1. A power supply circuit (10) in an integrated circuit including a reference generator circuit (18) coupled to receive a supply voltage (VCCEXT) and generate a reference voltage (VREF), a first converter circuit (24) comprising a first voltage converter (24) having a first input (27) coupled to receive said reference voltage (VREF) from said reference generator circuit (18), a second input (26) coupled to receive said supply voltage (VCCEXT), and an output (28) for generating a first output signal (VCC), said first converter circuit (24) being adapted to be coupled to a low voltage circuit (30) having an input (32) for receiving said first output signal (VCC), a second converter circuit (42) comprising a second voltage converter (42) coupled to receive the output of said first converter circuit (24), said second converter circuit (42) generating a second output signal (VCCP), said second converter circuit (42) being adapted to be coupled to a high voltage circuit (48) including an input (50) for receiving said second output signal (VCCP), wherein said power supply circuit further including a substrate bias generator circuit (34) coupled to receive said first output signal (VCC) and generate a substrate bias signal (VBB) to maintain the voltage at the substrate of the integrated circuit,
characterised in that:
- said first voltage converter is a voltage-down converter (24) adapted for generating a first controlled constant low output signal (VCC);
- said second voltage converter is a voltage-up converter (42) adapted for generating from said first output signal (VCC) a second controlled constant high output signal (VCCP), whereby said first (VCC) and second (VCCP) output signals as well as said substrate bias signal are substantially independent of variations of said supply voltage (VCCEXT).

2. The power supply circuit for an integrated circuit of Claim 1 wherein said first (VCC) and second (VCCP) output signals are substantially independent of variations of said supply voltage (VCCEXT) over a range between 3.0 and 5.5 volts.

3. The power supply circuit for an integrated circuit of claim 1 wherein said first output signal (VCC) is between approximately 3.0 and 3.6 volts.

4. The power supply circuit for an integrated circuit of Claim 1 wherein said high power supply voltage (VCCP) is between approximately 4.5 and 5.5 volts.

5. The power supply circuit for an integrated circuit of Claim 1 wherein the substrate bias generator includes a self-timed clock circuit (500).

6. The power supply circuit for an integrated circuit of Claim 1 or 5 wherein the substrate bias generator includes a voltage regulator circuit (400) coupled to the substrate (428) of said integrated circuit for monitoring the substrate voltage (V_{BB}).

7. The power supply circuit of Claim 6 wherein the voltage regulator circuit (400) outputs a clock enabling signal (PMP) when the voltage varies from a predetermined level, and wherein the self-timed clock circuit (200) is responsive to the clock enabling signal (PMP) for generating clock signals (CP1-CP4) when receiving the clock enabling signal (PMP).

8. The power supply circuit of Claim 8 wherein the substrate bias generator further includes a two-stage pump circuit (900) responsive to the clock signals (CP1-CP4) for pumping charge to the substrate (428) to alter the voltage at the substrate.

9. The power supply circuit of Claim 7 wherein the voltage regulator circuit (400) is a low-power regulator that is always active.

10. The power supply circuit for an integrated circuit of Claim 1 wherein the substrate bias generator includes a low current self-timed clock circuit (500) which is not free running and is responsive to an active clock enabling signal (PMP), a pump circuit (600) to pump charge and to lower the voltage (V_{BB}) of the substrate (428) of said integrated circuit, and wherein the self-timed clock circuit (500) ignores the clock enabling signal (PMP) until after the completion of the pumping.

11. The power supply circuit for an integrated circuit of Claim 1 wherein the voltage down converter circuit (24) is programmable to provide a voltage over a range of outputs.

12. The power supply circuit for an integrated circuit of Claim 11 wherein the voltage down converter circuit (24) includes a counter (45) for setting the first output signal during a test stage and fuse means for permanently setting the first output signal.

13. The power supply circuit for an integrated circuit of Claim 1 wherein the voltage up converter (42) includes a low-power standby pump circuit (1110, 1300, 1478) coupled to monitor said high voltage (VCCP) and pump charge to maintain said high voltage (VCCP), and an active pump circuit (1200, 1478', 1500) coupled to pump charge to maintain said high voltage (VCCP) during active cycles.

14. The voltage generator of Claim 13 wherein the standby pump circuit (1300) includes a self-timed clock circuit.

15. The voltage generator of Claim 13 wherein the standby pump in the voltage up converter is always active.

16. The power supply circuit for an integrated circuit of Claim 1 wherein the reference generator circuit (18) coupled to receive a supply voltage (VCCEXT) and generate a reference voltage (VREF) is temperature compensated.

## Patentansprüche

1. Spannungsversorgungsstufe (10) in einem integrierten Schaltkreis, wobei die Stufe (10) eine Bezugsgeneratorstufe (18) aufweist, die so geschaltet ist, daß sie eine Versorgungsspannung (VCCEXT) empfängt und eine Bezugsspannung (VREF) erzeugt; eine erste Umsetzerstufe (24) aufweist, die einen ersten Spannungsumsetzer (24) enthält, der einen ersten Eingang (27), der so geschaltet ist, um die Bezugsspannung (VREF) von der Bezugsgeneratorstufe (18) zu empfangen, einen zweiten Eingang (26), der so geschaltet ist, um die Versorgungsspannung (VCCEXT) zu empfangen, sowie einen Ausgang (28) besitzt, um ein erstes Ausgangssignal (VCC) zu erzeugen, wobei die erste Umsetzerstufe (24) so aufgebaut ist, um mit einer Stufe mit niedriger Spannung (30) verbunden zu werden, die einen Eingang (32) besitzt, um das erste Ausgangssignal (VCC) zu empfangen; eine zweite Umsetzerstufe (42) aufweist, die einen zweiten Spannungsumsetzer (42) enthält, der so geschaltet ist, um den Ausgang der ersten Umsetzerstufe (24) zu empfangen, wobei die zweite Umsetzerstufe (42) ein zweites Ausgangssignal (VCCP) erzeugt, wobei die zweite Umsetzerstufe (42) so aufgebaut ist, um mit einer Stufe mit hoher Spannung (48) verbunden zu werden, die einen Eingang (50) aufweist, um das zweite Ausgangssignal (VCCP) zu empfangen; und wobei die Spannungsversorgungsstufe weiters einen substratvorspannungsgenerator (34) aufweist, der so geschaltet ist, um das erste Ausgangssignal (VCC) zu empfangen und ein Substratvorspannungssignal (VBB) zu erzeugen, um die Spannung am Substrat des integrierten Schaltkreises aufrechtzuerhalten,
dadurch gekennzeichnet, daß:
- der erste Spannungsumsetzer ein Umsetzer auf eine niedrige Spannung (24) ist, der so aufgebaut ist, um ein erstes geregeltes, konstantes, niedriges Ausgangssignal (VCC) zu erzeugen;
- der zweite Spannungsumsetzer ein Umsetzer auf eine höhere Spannung(42) ist, der so aufgebaut ist, um aus dem ersten Ausgangssignal (VCC) ein zweites geregeltes, konstantes, hohes Ausgangssignal (VCCP) zu erzeugen, wobei das erste (VCC) und das zweite (VCCP) Ausgangssignal sowie das Substratvorspannungssignal von Änderungen der Versorgungsspannung (VCCEXT) im wesentlichen unabhängig sind.

2. Spannungsversorgungsstufe für einen integrierten Schaltkreis gemäß Anspruch 1, wobei das erste (VCC) und das zweite (VCCP) Ausgangssignal von Änderungen der Versorgungsspannung (VCCEXT) über einen Bereich zwischen 3,0 und 5,5 Volt im wesentlichen unabhängig sind.

3. Spannungsversorgungsstufe für einen integrierten Schaltkreis gemäß Anspruch 1, wobei das erste Ausgangssignal (VCC) zwischen etwa 3,0 und 3,6 Volt liegt.

4. Spannungsversorgungsstufe für einen integrierten Schaltkreis gemäß Anspruch 1, wobei die hohe Versorgungsspannung (VCCP) zwischen etwa 4,5 und 5,5 Volt liegt.

5. Spannungsversorgungsstufe für einen integrierten Schaltkreis gemäß Anspruch 1, wobei der Substratvorspannungsgenerator eine selbstauslösende Taktstufe (500) aufweist.

6. Spannungsversorgungsstufe für einen integrierten Schaltkreis gemäß Anspruch 1 oder 5, wobei der Substratvorspannungsgenerator eine Spannungsregelstufe (400) aufweist, die mit dem Substrat (428) des integrierten Schaltkreises verbunden ist, um die Substratvorspannung (V_{BB}) zu überwachen.

7. Spannungsversorgungsstufe gemäß Anspruch 6, wobei die Spannungsregelstufe (400) ein Takteinschaltsignal (PMP) abgibt, wenn sich die Spannung von einem vorgegebenen Pegel ändert, und wobei die selbstauslösende Taktstufe (200) auf das Takteinschaltsignal (PMP) anspricht, um Taktsignale (CP1-CP4) zu erzeugen, wenn sie das Takteinschaltsignal (PMP) empfängt.

8. Spannungsversorgungsstufe gemäß Anspruch 8, wobei der Substratvorspannungsgenerator weiters eine zweistufige Pumpstufe (900) aufweist, die auf die Taktsignale (CP1-CP4) anspricht, um Ladung zum Substrat (428) zu pumpen, um die Spannung am Substrat zu ändern.

9. Spannungsversorgungsstufe gemäß Anspruch 7, wobei die Spannungsregelstufe (400) ein Regler mit niedriger Leistung ist, der immer in Betrieb steht.

10. Spannungsversorgungsstufe für einen integrierten Schaltkreis gemäß Anspruch 1, wobei der Substratvorspannungsgenerator eine selbstauslösende Niedrigstromtaktstufe (500) aufweist, die nicht freiläuft und auf ein aktives Takteinschaltsignal (PMP) anspricht; einen Pumpstufe (600) aufweist, um Ladung zu pumpen und die Spannung (V_{BB}) des Substrats (428) des integrierten Schaltkreises herabzusetzen, und wobei die selbstauslösende Taktstufe (500) das Takteinschaltsignal (PMP) ignoriert, bis der Pumpvorgang beendet ist.

11. Spannungsversorgungsstufe für einen integrierten Schaltkreis gemäß Anspruch 1, wobei der Umsetzer auf eine niedrige Spannung (24) programmierbar ist, um eine Spannung über einen Bereich von Ausgängen zu liefern.

12. Spannungsversorgungsstufe für einen integrierten Schaltkreis gemäß Anspruch 11, wobei der Umsetzer auf eine niedrige Spannung (24) einen Zähler (45) aufweist, um das erste Ausgangssignal während eines Prüfintervalls einzustellen, sowie eine Sicherungsstufe aufweist, um das erste Ausgangssignal dauernd einzustellen.

13. Spannungsversorgungsstufe für einen integrierten Schaltkreis gemäß Anspruch 1, wobei der Umsetzer auf eine höhere Spannung (42) eine Bereitschaftspumpstufe mit niedriger Leistung (1110, 1300, 1478) aufweist, die so geschaltet ist, um die hohe Spannung (VCCP) zu überwachen und Ladung zu pumpen, um die hohe Spannung (VCCP) aufrechtzuerhalten, sowie eine aktive Pumpstufe (1200, 1478', 1500) aufweist, die so geschaltet ist, um Ladung zu pumpen, um die hohe Spannung (VCCP) während aktiver Intervalle aufrechtzuerhalten.

14. Spannungsgenerator gemäß Anspruch 13, wobei die Bereitschaftspumpstufe (1300) eine selbstauslösende Taktstufe aufweist.

15. Spannungsgenerator gemäß Anspruch 13, wobei die Bereitschaftspumpstufe im Umsetzer auf eine höhere Spannung immer in Betrieb steht.

16. Spannungsversorgungsstufe für einen integrierten Schaltkreis gemäß Anspruch 1, wobei die Bezugsgeneratorstufe (18), die so geschaltet ist, um eine Versorgungsspannung (VCCEXT) zu empfangen und eine Bezugsspannung (VREF) zu erzeugen, temperaturkompensiert ist.

## Revendications

1. Circuit d'alimentation électrique (10) dans un circuit intégré incluant un circuit générateur de référence (18) couplé pour recevoir une tension d'alimentation (VCCEXT) et générer une tension de référence (VREF), un premier circuit convertisseur (24) comprenant un premier convertisseur de tension (24) ayant une première entrée (27) couplée pour recevoir ladite tension de référence (VREF) à partir dudit circuit générateur de référence (18), une seconde entrée (26) couplée pour recevoir ladite tension d'alimentation (VCCEXT), et une sortie (28) pour générer un premier signal de sortie (VCC), ledit premier circuit convertisseur (24) étant conçu pour être couplé à un circuit à bas niveau de tension (30) ayant une entrée (32) pour recevoir ledit premier signal de sortie (VCC), un second circuit convertisseur (42) comprenant un second convertisseur de tension (42) couplé pour recevoir la sortie dudit premier circuit convertisseur (24), ledit second circuit convertisseur (42) générant un second signal de sortie (VCCP), ledit second circuit convertisseur (42) étant conçu pour être couplé à un circuit à haut niveau de tension (48) incluant une entrée (50) pour recevoir ledit second signal de sortie (VCCP), dans lequel ledit circuit d'alimentation électrique incluant, en outre, un circuit générateur de polarisation de substrat (34) couplé pour recevoir ledit premier signal de sortie (VCC) et générer un signal de polarisation de substrat (VBB) afin de maintenir la tension au substrat du circuit intégré,
caractérisé en ce que:
- ledit premier convertisseur de tension est un convertisseur de diminution de tension (24) conçu pour générer un premier signal de sortie à bas niveau, constant et régulé (VCC);
- ledit second convertisseur de tension est un convertisseur d'augmentation de tension (42) conçu pour générer, à partir dudit premier signal de sortie (VCC), un second signal de sortie à niveau haut, constant et régulé (VCCP), dans lequel lesdits premier (VCC) et second (VCCP) signaux de sortie ainsi que ledit signal de polarisation de substrat sont sensiblement indépendants des variations de ladite tension d'alimentation (VCCEXT).

2. Circuit d'alimentation électrique pour un circuit intégré selon la revendication 1, dans lequel lesdits premier (VCC) et second (VCCP) signaux de sortie sont sensiblement indépendants des variations de ladite tension d'alimentation (VCCEXT) sur une plage comprise entre 3,0 et 5,5 volts.

3. Circuit d'alimentation électrique pour un circuit intégré selon la revendication 1, dans lequel ledit premier signal de sortie (VCC) est compris entre environ 3,0 et 3,6 volts.

4. Circuit d'alimentation électrique pour un circuit intégré selon la revendication 1, dans lequel ladite tension d'alimentation à grande puissance (VCCP) est comprise entre environ 4,5 et 5,5 volts.

5. Circuit d'alimentation électrique pour un circuit intégré selon la revendication 1, dans lequel le générateur de polarisation de substrat inclut un circuit d'horloge auto-cadencé (500).

6. Circuit d'alimentation électrique pour un circuit intégré selon la revendication 1 ou 5, dans lequel le générateur de polarisation de substrat inclut un circuit régulateur de tension (400) couplé au substrat (428) dudit circuit intégré permettant de contrôler la tension du substrat (V_{BB}).

7. Circuit d'alimentation électrique selon la revendication 6, dans lequel le circuit régulateur de tension (400) délivre un signal de validation d'horloge (PMP) lorsque la tension varie à partir un niveau prédéterminé, et dans lequel le circuit d'horloge auto-cadencé (200) est sensible au signal de validation d'horloge (PMP) pour générer des signaux d'horloge (CP1-CP4) lors de la réception du signal de validation d'horloge (PMP).

8. Circuit d'alimentation électrique selon la revendication 8, dans lequel le générateur de polarisation de substrat inclut, en outre, un circuit de pompage à deux étages (900) sensible aux signaux d'horloge (CP1-CP4) pour pomper une charge au substrat (428) afin de modifier la tension au substrat.

9. Circuit d'alimentation électrique selon la revendication 7, dans lequel le circuit régulateur de tension (400) est un régulateur à faible puissance qui demeure toujours actif.

10. Circuit d'alimentation électrique pour un circuit intégré selon la revendication 1, dans lequel le générateur de polarisation de substrat inclut un circuit d'horloge auto-cadencé à faible courant (500) qui n'est pas en fonctionnement non synchronisé et qui est sensible à un signal de validation d'horloge actif (PMP), un circuit de pompage (600) pour pomper une charge et diminuer la tension (V_{BB}) du substrat (428) dudit circuit intégré, et dans lequel le circuit d'horloge auto-cadencé (500) ignore le signal de validation d'horloge (PMP) jusqu'à l'achèvement du pompage.

11. Circuit d'alimentation électrique pour un circuit intégré selon la revendication 1, dans lequel le circuit convertisseur de diminution de tension (24) peut être programmé pour délivrer une tension sur une plage de signaux de sortie.

12. Circuit d'alimentation électrique pour un circuit intégré selon la revendication 11, dans lequel le circuit convertisseur de diminution de tension (24) inclut un compteur (45) pour fixer le premier signal de sortie au cours d'une phase de test et des moyens à fusible pour fixer, de façon permanente, le premier signal de sortie.

13. Circuit d'alimentation électrique pour un circuit intégré selon la revendication 1, dans lequel le convertisseur d'augmentation de tension (42) inclut un circuit de pompage en attente et à faible puissance (1110, 1300, 1478) couplé pour contrôler ladite haute tension (VCCP) et pour pomper une charge afin de maintenir ladite haute tension (VCCP), et un circuit de pompage actif (1200, 1478', 1500) couplé pour pomper une charge afin de maintenir ladite haute tension (VCCP) au cours des cycles actifs.

14. Générateur de tension selon la revendication 13, dans lequel le circuit de pompage en attente (1300) inclut un circuit d'horloge auto-cadencé.

15. Générateur de tension selon la revendication 13, dans lequel le circuit de pompage en attente du convertisseur d'augmentation de tension demeure toujours actif.

16. Circuit d'alimentation électrique pour un circuit intégré selon la revendication 1, dans lequel le circuit générateur de référence (18) couplé pour recevoir une tension d'alimentation (VCCEXT) et générer une tension de référence (VREF) est à compensation thermique.
